# EUROPEAN PATENT APPLICATION

(11) **EP 4 808 322 A1**
(43) Date of publication of application: **16.09.2026**
(21) Application number: 24951692.3
(22) Date of filing: 14.09.2024
(51) Int. Cl.: H10K 59/121

(54) **DISPLAY PANEL AND DISPLAY DEVICE**

(30) Priority: 23.08.2024 CN 202411173759
(71) Applicant: Wuhan Tianma Microelectronics Co., Ltd., Wuhan, Hubei 430205 (CN)
(72) Inventor: MA, Yangzhao, Wuhan, Hubei 430205 (CN); YIN, Zhaodi, Wuhan, Hubei 430205 (CN); WU, Fengyun, Wuhan, Hubei 430205 (CN); CHEN, Shengxiong, Wuhan, Hubei 430205 (CN); LI, Fei, Wuhan, Hubei 430205 (CN)
(74) Representative: Völkl Siebenson Patentanwälte - Partnerschaft mbB
(86) International application number: PCT/CN2024/118972
(87) International publication number: WO 2026/040145

(57) **Abstract**

Embodiments of the present disclosure relate to the technical field of display, and provide a display panel and a display device, used for cutting off or extending a transmission path of a transverse leakage current between two adjacent sub-pixels and ensuring the connection reliability of second electrodes of sub-pixels. In the display panel, at least one of a non-notch portion of a first partition portion, a non-notch portion of a second partition portion, and a support portion is comprised between a first sub-pixel and a second sub-pixel adjacent to each other; at least one of the first sub-pixel and the second sub-pixel comprises a first protruding portion and a main body portion; and the edge of the first protruding portion away from the main body portion comprises an arc segment, and the arc segment protrudes towards the side away from the main body portion.

## Description

The present application claims priority to Chinese Patent Application No. 202411173759.X, entitled "DISPLAY PANEL AND DISPLAY APPARATUS", filed before China National Intellectual Property Administration on August 23, 2024, the entireties of which are incorporated herein by reference.

### TECHNICAL FIELD

The present disclosure relates to the field of display technology, and in particular, to a display panel and a display apparatus.

### BACKGROUND

Organic light-emitting diode (hereinafter referred to as OLED) display panels are widely used in the field of display technology because they have many advantages such as active light emission, high contrast, and no viewing angle limitation.

In an OLED display panel, in order to enhance the migration and recombination efficiency of carriers, functional film layers such as an electron transport layer, an electron injection layer, a hole transport layer, and a hole injection layer are typically disposed between the electrodes and the light-emitting layer of an OLED device. However, because these functional film layers are generally common to all organic light-emitting devices in the display panel, when the display panel displays pictures, carriers corresponding to different OLED devices may laterally migrate between different OLED devices through the above-mentioned functional film layers, in addition to the normal longitudinal migration from respective cathodes and/or anodes to corresponding light-emitting layers. That is, lateral leakage current occurs, resulting in mutual crosstalk between different sub-pixels when the display panel displays pictures. This may cause a phenomenon where sub-pixels that should not emit light emit light, i.e., an unintended light emission phenomenon, which affects the display effect.

### SUMMARY

In view of the above, the present disclosure provides a display panel and a display apparatus to solve a problem in the related art that the lateral leakage current causes unintended light emission of light-emitting devices.

In a first aspect, an embodiment of the present disclosure provides a display panel, including:
a substrate;
multiple sub-pixels disposed on a same side of the substrate and arranged in an array along a first direction and a second direction, the multiple sub-pixels including first sub-pixels, second sub-pixels, and third sub-pixels, where a first row of the multiple sub-pixels includes the first sub-pixels and the third sub-pixels alternately arranged along the first direction, a second row, which is adjacent to the first row, of the multiple sub-pixels includes the third sub-pixels and the second sub-pixels alternately arranged along the first direction, a first column of the multiple sub-pixels includes the first sub-pixels and the third sub-pixels alternately arranged along the second direction, and a second column, which is adjacent to the first column, of the multiple sub-pixels includes the third sub-pixels and the second sub-pixels alternately arranged along the second direction, and the second direction is non-parallel to the first direction; and
partition portions, at least including: at least one first partition portion, each at least partially surrounding a respective one of the first sub-pixels and including at least one first notch; and at least one second partition portion, each at least partially surrounding a respective one of the second sub-pixels and including at least one second notch; and
at least one support portion, where for each support portion: along a third direction, the support portion is disposed between a respective first sub-pixel of the first sub-pixels and a second sub-pixel, adjacent to the respective first sub-pixel, of the second sub-pixels, and along a fourth direction, the support portion is disposed between two respective adjacent third sub-pixels of the third sub-pixels, and the third direction is non-parallel to each of the first direction and the second direction, the fourth direction is non-parallel to each of the first direction and the second direction, and the third direction is non-parallel to the fourth direction,
where for each pair of a first sub-pixel of the first sub-pixels and a second sub-pixel, adjacent to the first sub-pixel, of the second sub-pixels: at least one of a non-notch portion of the first partition portion, a non-notch portion of the second partition portion, or the support portion is disposed between the first sub-pixel and the second sub-pixel, at least one of the first sub-pixel or the second sub-pixel includes a protrusion portion and a body portion, and an edge of the protrusion portion away from the body portion includes an arc protruding away from the body portion.

In a second aspect, an embodiment of the present disclosure provides a display apparatus including the display panel.

In the display panel and the display apparatus according to the embodiments of the present disclosure, by providing the at least one first partition portion, each partially surrounding the respective first sub-pixel, and the at least one second partition portion, each partially surrounding the respective second sub-pixel, a path for a lateral leakage current to flow between the first sub-pixel and an adjacent sub-pixel through a common layer is blocked or extended, and a path for a lateral leakage current to flow between the second sub-pixel and an adjacent sub-pixel through the common layer is blocked or extended. This can inhibit the flow of the lateral leakage current, thereby improving the display effect, particularly at low gray scales.

Moreover, in the embodiments of the present disclosure, the provision of at least one first notch in each of the at least one first partition portion and at least one second notch in each of the at least one second partition portion prevents the disconnection or thickness reduction of a second electrode-formed after the first partition portion and the second partition portion-at the notches, so that at the notches, the second electrode is formed as a continuous structure with a large thickness. As a result, a voltage drop of a signal transmitted through the second electrode is reduced, improving the voltage uniformity of the second electrode in the display region.

In addition, in the embodiments of the present disclosure, the display panel is provided with the at least one support portion for supporting a mask used in the manufacturing process. Moreover, the provision of the support portion extends a path for a lateral leakage current to flow between two adjacent sub-pixels through the common layer, thereby suppressing the flow of the lateral leakage current and improving the reliability of the display panel.

Further, in the embodiments of the present disclosure, when providing the at least one first notch, the at least one second notch and the support portion, by providing at least one of a non-notch portion of the first partition portion, a non-notch portion of the second partition portion or the support portion between each pair of the first sub-pixel and the second sub-pixel that are adjacent to each other, and by comprehensively considering the positions of the first notch, the second notch and the support portion, the provision of both the first notch and the second notch between the first sub-pixel and the second sub-pixel that are adjacent to each other, between which there is no support portion, is avoided. Moreover, it is ensured that at least one suppression structure for extending or blocking the conduction path of the lateral leakage current is provided between the first sub-pixel and the second sub-pixel that are adjacent to each other, between which there is no support portion, to suppress the flow of the lateral leakage current between the first sub-pixel and the second sub-pixel. As a result, the possibility of crosstalk between the first sub-pixel and the second sub-pixel is reduced, reducing the possibility of unintended light emission of the first sub-pixel and the second sub-pixel, optimizing low-gray-scale display performance of the display panel, and improving display quality of the display panel.

In addition, in the embodiments of the present disclosure, at least one of the first sub-pixel or the second sub-pixel includes the protrusion portion and the body portion, the edge of the protrusion portion away from the body portion includes the arc protruding away from the body portion, and the protrusion portion and the body portion may be disposed in a virtual circumscribed quadrilateral of the first sub-pixel or the second sub-pixel. On one hand, compared with the case where the first sub-pixel and the second sub-pixel are shaped in accordance with respective virtual circumscribed quadrilaterals, by using the arrangement provided by the embodiments of the present disclosure, the area of the first sub-pixel or the second sub-pixel is reduced, thereby increasing the distance between the first sub-pixel or the second sub-pixel and another sub-pixel adjacent thereto. This reduces the difficulty in disposing the partition portion and/or the support portion between the first sub-pixel and another sub-pixel adjacent thereto, as well as between the second sub-pixel and another sub-pixel adjacent thereto.

On the other hand, in the embodiments of the present disclosure, while ensuring that a minimum spacing between two adjacent sub-pixels remains unchanged, by configuring either the first sub-pixel or the second sub-pixel to include the protrusion portion, which is equivalent to arc-cutting corresponding corners of the virtual circumscribed quadrilateral corresponding to the first sub-pixel or the second sub-pixel, at least one corner of the first sub-pixel or the second sub-pixel is caused to move inward toward the center of the virtual circumscribed quadrilateral of the first sub-pixel or the second sub-pixel, which creates additional space to allow another sub-pixel adjacent to this sub-pixel to expand outward, thereby increasing the area of the expanded sub-pixel and improving its aperture ratio, as compared to a configuration in which either the first sub-pixel or the second sub-pixel has a square shape. Moreover, compared with the related art, the pixel design according to the embodiments of the present disclosure increases the total aperture ratio of a pixel unit including one first sub-pixel, one second sub-pixel, and two third sub-pixels, without increasing the process difficulty, such as when the relevant process parameters (such as the minimum opening spacing between adjacent sub-pixels, FMM rib width, etc.) are consistent with those in the prior art or have additional design margin. Such improvement enhances the display effect and the display quality of the display panel.

### BRIEF DESCRIPTION OF DRAWINGS

In order to describe the technical solutions in the embodiments of the present disclosure more clearly, the drawings used in the description of the embodiments will be introduced briefly below. Apparently, the drawings in the following description are merely some of the embodiments of the present disclosure. For those of ordinary skill in the art, other drawings may also be obtained based on these drawings without any creative efforts.
FIG. 1 is a schematic diagram of a display panel according to an embodiment of the present disclosure;
FIG. 2 is a schematic diagram of a cross-section of a display panel according to an embodiment of the present disclosure;
FIG. 3 is a schematic diagram of a cross-section of a display panel according to another embodiment of the present disclosure;
FIG. 4 is a schematic diagram of a cross-section of a display panel according to yet another embodiment of the present disclosure;
FIG. 5 is a schematic diagram of a cross-section of a display panel according to yet another embodiment of the present disclosure;
FIG. 6 is a schematic diagram of a cross-section of a first sub-pixel, a second sub-pixel and a support portion according to an embodiment of the present disclosure;
FIG. 7 is a schematic diagram of a display panel according to another embodiment of the present disclosure;
FIG. 8 is a schematic diagram of a display panel according to yet another embodiment of the present disclosure;
FIG. 9 is a schematic diagram of a display panel according to yet another embodiment of the present disclosure;
FIG. 10 is a schematic diagram of a display panel according to yet another embodiment of the present disclosure;
FIG. 11 is a schematic diagram of a display panel according to yet another embodiment of the present disclosure;
FIG. 12A is an enlarged schematic diagram of a sub-pixel including a protrusion portion and a body portion according to an embodiment of the present disclosure;
FIG. 12B is a schematic diagram of a display panel in the related art;
FIG. 12C is an enlarged schematic diagram of a sub-pixel including a protrusion portion and a body portion according to another embodiment of the present disclosure;
FIG. 12D is a schematic diagram of a comparison between a display panel according to an embodiment of the present disclosure and the display panel in the related art shown in FIG. 12B;
FIG. 13 is an enlarged schematic diagram of a first first sub-pixel, a first partition portion and a support portion according to an embodiment of the present disclosure;
FIG. 14 is an enlarged schematic diagram of a first first sub-pixel, a first partition portion and a support portion according to another embodiment of the present disclosure;
FIG. 15 is an enlarged schematic diagram of a second first sub-pixel and a first partition portion according to an embodiment of the present disclosure;
FIG. 16 is a schematic diagram of a display panel according to yet another embodiment of the present disclosure;
FIG. 17 is an enlarged schematic diagram of a first-type sub-pixel, a second-type sub-pixel, a third-type sub-pixel and a fourth-type sub-pixel in FIG. 16;
FIG. 18 is an enlarged schematic diagram of a first second sub-pixel, a third partition sub-portion and a support portion according to an embodiment of the present disclosure;
FIG. 19 is an enlarged schematic diagram of a first second sub-pixel, a third partition sub-portion and a support portion in FIG. 16;
FIG. 20 is a schematic diagram of a display panel according to yet another embodiment of the present disclosure;
FIG. 21 is a schematic diagram of a display panel according to yet another embodiment of the present disclosure;
FIG. 22 is an enlarged schematic diagram of a first second sub-pixel, a third partition sub-portion and a support portion in FIG. 21;
FIG. 23 is a schematic diagram of a display panel according to yet another embodiment of the present disclosure;
FIG. 24 is an enlarged schematic diagram of a first second sub-pixel, a third partition sub-portion and a support portion in FIG. 23;
FIG. 25 is a schematic diagram of a display panel according to yet another embodiment of the present disclosure;
FIG. 26 is a schematic diagram of a display panel according to yet another embodiment of the present disclosure;
FIG. 27 is a schematic diagram of a display panel according to yet another embodiment of the present disclosure;
FIG. 28 is an enlarged schematic diagram of a third sub-pixel and a third partition portion according to an embodiment of the present disclosure;
FIG. 29 is a schematic diagram of a display panel according to yet another embodiment of the present disclosure;
FIG. 30 is a schematic diagram of a display panel according to yet another embodiment of the present disclosure;
FIG. 31 is a schematic diagram of a display panel according to yet another embodiment of the present disclosure;
FIG. 32 is a schematic diagram of a cross-section of a display panel according to yet another embodiment of the present disclosure; and
FIG. 33 is a schematic diagram of a display apparatus according to an embodiment of the present disclosure.

### DESCRIPTION OF EMBODIMENTS

In order to better understand the technical solutions of the present disclosure, the embodiments of the present disclosure will be described in detail below in conjunction with the accompanying drawings.

It should be clear that the described embodiments are only a part of, rather than all of, the embodiments of the present disclosure. All other embodiments obtained by those of ordinary skill in the art based on the embodiments of the present disclosure without creative efforts shall fall within the protection scope of the present disclosure.

The terms used in the embodiments of the present disclosure are only for the purpose of describing specific embodiments and are not intended to limit the present disclosure. The singular forms "a," "an," and "the" used in the embodiments of the present disclosure and the appended claims are also intended to include plural forms, unless the context clearly indicates otherwise.

It should be understood that the term "and/or" used herein is merely an association relationship describing associated objects, indicating that there can be three relationships. For example, A and/or B can represent the following three situations: A exists alone, both A and B exist simultaneously, and B exists alone. In addition, the character "/" herein generally indicates an "or" relationship between the associated objects before and after it.

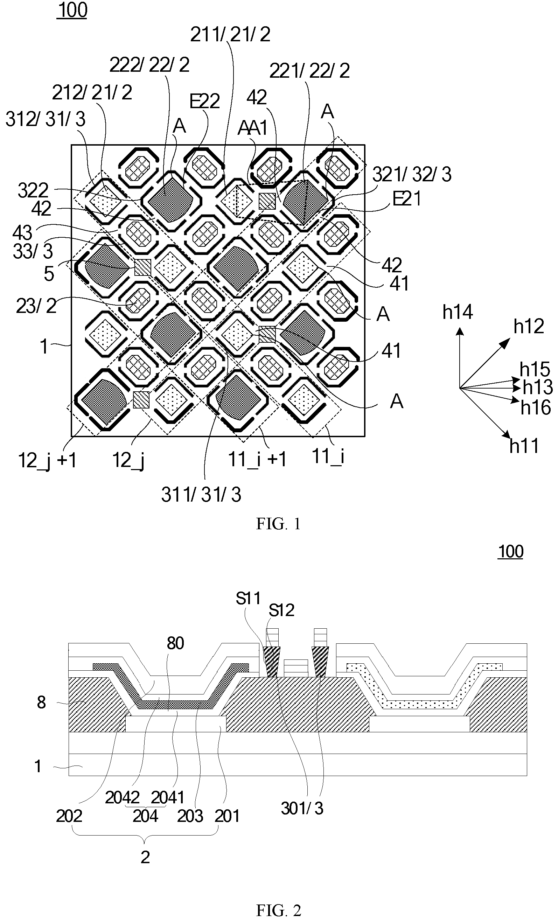

An embodiment of the present disclosure provides a display panel. As shown in FIG. 1, which is a schematic diagram of a display panel according to an embodiment of the present disclosure, the display panel 100 includes: a substrate 1; and multiple sub-pixels 2 arranged in an array along a first direction h11 and a second direction h12 on a same side of the substrate 1. The sub-pixels 2 include first sub-pixels 21, second sub-pixels 22 and third sub-pixels 23, configured to emit light of different colors. For example, the first sub-pixels 21 include a red sub-pixel, the second sub-pixels 22 include a blue sub-pixel, and the third sub-pixels 23 include a green sub-pixel.

As shown in FIG. 1, an i-th row of the sub-pixels 11_i includes first sub-pixels 21 and third sub-pixels 23 alternately arranged along the first direction h11. An (i+1)-th row of the sub-pixels 11_i+1 includes third sub-pixels 23 and second sub-pixels 22 alternately arranged along the first direction h11. A j-th column of the sub-pixels 12_j includes first sub-pixels 21 and third sub-pixels 23 alternately arranged along the second direction h12. A (j+1)-th column of the sub-pixels 12_j+1 includes third sub-pixels 23 and second sub-pixels 22 alternately arranged along the second direction h12. The second direction h12 intersects the first direction h11. Herein, both i and j are positive integers. The intersection of the second direction h12 and the first direction h11 defines a plane of the substrate 1, and as schematically illustrated in FIG. 1, the second direction h12 is perpendicular to the first direction h11.

For example, as shown in FIG. 1, the display panel 100 further includes partition portions 3. The partition portions 3 include a first partition portion 31 and a second partition portion 32. The first partition portion 31 at least partially surrounds the first sub-pixel 21, and the second partition portion 32 at least partially surrounds the second sub-pixel 22.

For example, as shown in FIG. 2, which is a schematic diagram of a cross-section of a display panel according to an embodiment of the present disclosure, the sub-pixel 2 includes a first electrode 201, a light-emitting layer 203, a second electrode 202 and a common layer 204. The partition portion 3 is located at a side of the common layer 204 close to the substrate 1. Optionally, the common layer 204 includes a first common sub-layer 2041 and a second common sub-layer 2042. The first common sub-layer 2041 is located between the first electrode 201 and the light-emitting layer 203, and the second common sub-layer 2042 is located between the second electrode 202 and the light-emitting layer 203. Optionally, the common layer 204 may be prepared using a common mask. The light-emitting layer 203 may be prepared using a fine metal mask (FMM).

Optionally, as shown in FIG. 2, the display panel 100 further includes a pixel-defining layer 8. The pixel-defining layer 8 has an opening 80. The opening 80 exposes at least a part of the first electrode 201.

In the embodiment of the present disclosure, the first electrodes 201 of different sub-pixels 2 are independent of each other, and the second electrodes 202 of the multiple sub-pixels 2 are electrically connected to each other.

In an implementation, the first electrode 201 includes an anode, and the second electrode 202 includes a cathode. The first common sub-layer 2041 includes a hole injection layer and/or a hole transport layer. The second common sub-layer 2042 includes an electron injection layer and/or an electron transport layer.

As shown in FIG. 2, the partition portion 3 includes a protrusion portion 301 protruding away from the substrate 1. In an implementation, the protrusion portion 301 includes a first side surface S11 and a first bottom surface S12 close to the surface of the substrate 1. In the embodiment of the present disclosure, an included angle, oriented toward the interior of the protrusion portion 301, between the first side surface S11 and the first bottom surface S12 is an obtuse angle. That is, a top surface of the protrusion portion 301 has a greater area than the bottom surface of the protrusion portion 301. Based on this arrangement, the common layer 204 formed after the protrusion portion 301 cannot be formed (or continuously formed) on the first side surface S11 and thus is discontinuous at the protrusion portion 301, so that a lateral leakage current path between two adjacent sub-pixels 2 via the common layer 204 is blocked, thereby suppressing the flow of the lateral leakage current and improving the display effect of the display panel.

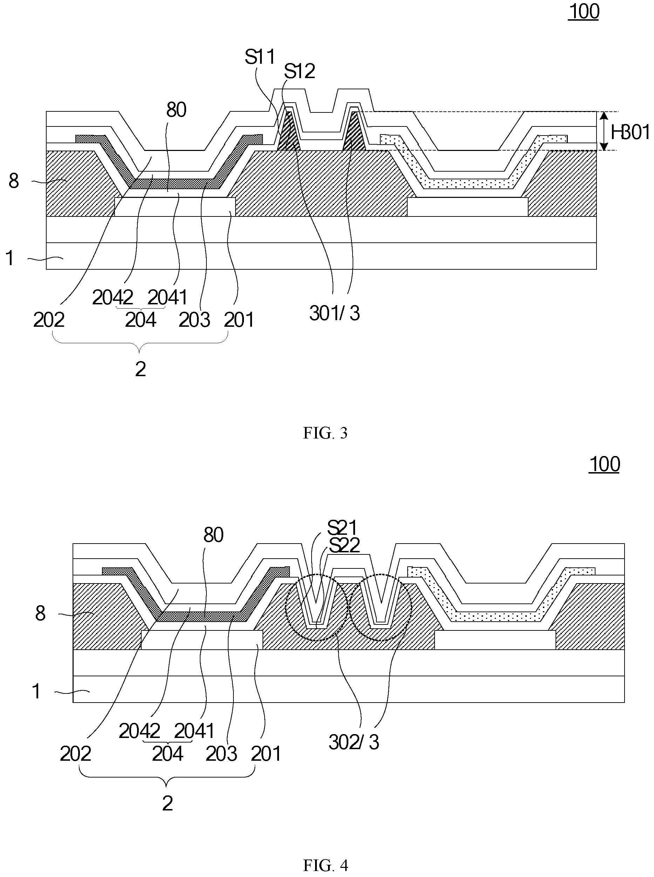

In another optional implementation, as shown in FIG. 3, which is a schematic diagram of a cross-section of a display panel according to another embodiment of the present disclosure, the included angle, oriented toward the interior of the protrusion portion 301, between the first side surface S11 and the first bottom surface S12 is an acute angle. That is, the top surface of the protrusion portion 301 has a smaller area than the bottom surface. Based on this arrangement, the common layer 204 formed after the protrusion portion 301 is formed on the first side surface S11. Based on the morphological characteristics of the protrusion portion 301, the lateral leakage current path between two adjacent sub-pixels 2 via the common layer 204 is extended, thereby suppressing the flow of the lateral leakage current and improving the display effect of the display panel.

In yet another optional implementation, as shown in FIG. 4, which is a schematic diagram of a cross-section of a display panel according to yet another embodiment of the present disclosure, the partition portion 3 includes a recessed portion 302 recessed toward the substrate 1. The recessed portion 302 includes a second side surface S21 and a second bottom surface S22 close to the surface of the substrate 1. As shown in FIG. 4, an included angle between the second side surface S21 and the second bottom surface S22 is an obtuse angle. Based on this arrangement, the common layer 204 formed after the recessed portion 302 is formed on the second side surface S21 of the recessed portion 302. Based on the morphological characteristics of the recessed portion 302, the lateral leakage current path between two adjacent sub-pixels 2 via the common layer 204 is extended, thereby suppressing the flow of the lateral leakage current and improving the display effect of the display panel.

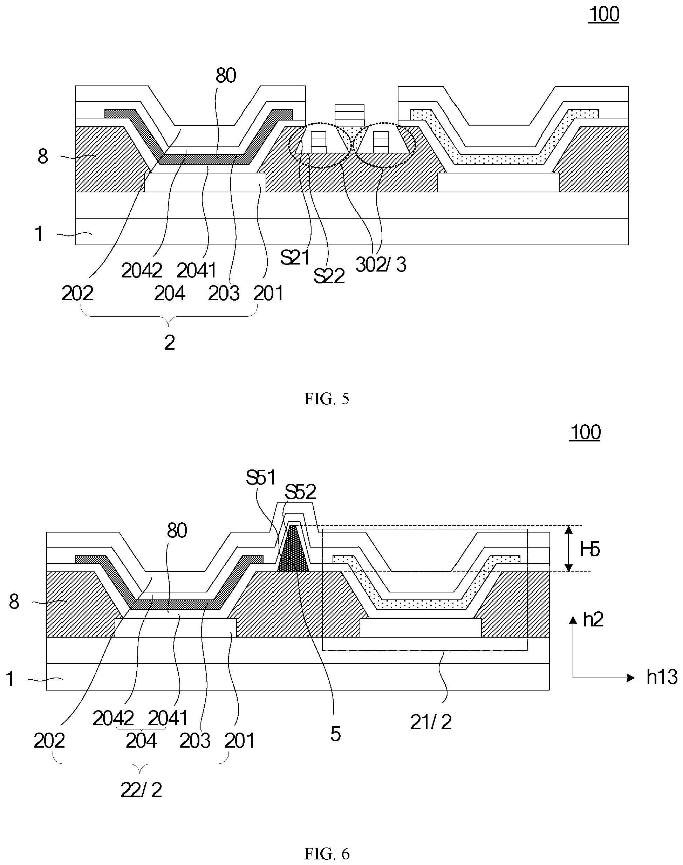

In yet another optional implementation, as shown in FIG. 5, which is a schematic diagram of a cross-section of a display panel according to yet another embodiment of the present disclosure, the included angle between the second side surface S21 and the second bottom surface S22 is an acute angle. Based on this arrangement, the common layer 204 formed after the recessed portion 302 cannot be formed on the second side surface S21 and thus is discontinuous at the recessed portion 302, so that the lateral leakage current path between two adjacent sub-pixels 2 via the common layer 204 is blocked, thereby suppressing the flow of the lateral leakage current and improving the display effect of the display panel.

For example, as shown in FIG. 4 and FIG. 5, in the embodiments of the present disclosure, the recessed portion 302 is disposed in the pixel-defining layer 8.

For example, when manufacturing the display panel, the pixel-defining layer 8 is formed after the first electrode 201 is formed, and then a support portion 5 and an opening 80 are formed by patterning the pixel-defining layer 8 with a half-tone mask. After the formation of the support portion 5 and the opening 80, a hard mask layer may be formed at a side of the support portion 5 away from the substrate 1. The hard mask layer includes multiple regions with different transmittances, and in an implementation, the transmittance of a region in the hard mask layer that corresponds to the partition portion 3 is different from the transmittance of other regions. Under the blocking effect of the hard mask layer, the pixel-defining layer 8 is etched, for example, by dry etching, by which it is beneficial to increasing a depth of the recessed portion 302 formed in the pixel-defining layer 8. When subsequently formed, the common layer extends into the recessed portion 302, resulting in an elongated lateral path of the common layer and thus an extended lateral leakage current path. Thus, the flow of the leakage current is suppressed and the problem of unintended light emission of the sub-pixels is effectively avoided.

In an implementation, the hard mask layer may be removed after the formation of the recessed portion 302. The method for removing the hard mask layer includes wet etching.

For example, the hard mask layer may be an IZO (Indium Zinc Oxide) layer.

In another optional implementation, after the formation of the pixel-defining layer 8, a photoresist is applied on the pixel-defining layer 8, and then exposed and developed to form an etch mask, through which the recessed portion 302 is formed in the pixel-defining layer 8 by etching. In this way, side walls and top corners of the recessed portion 302 are smoother, thereby reducing defects.

For example, as shown in FIG. 4 and FIG. 5, in an embodiment of the present disclosure, a depth of the recessed portion 302 may be less than a thickness of the pixel-defining layer 8, i.e., the second bottom surface S22 of the recessed portion 302 is located inside the pixel-defining layer 8. Alternatively, in an embodiment of the present disclosure, the depth of the recessed portion 302 may be equal to the thickness of the pixel-defining layer 8, i.e., the recessed portion 302 extends through the pixel-defining layer 8. In another optional implementation, the depth of the recessed portion 302 may be greater than the thickness of the pixel-defining layer 8, i.e., the recessed portion 302 extends through the pixel-defining layer 8 and further extends toward the substrate 1, so that the second bottom surface S22 of the recessed portion 302 is located within an organic layer between the pixel-defining layer 8 and the substrate 1. For example, a planarization layer may be further included between the pixel-defining layer 8 and the substrate 1, and in the embodiment of the present disclosure, the second bottom surface S22 of the recessed portion 302 may be located within the planarization layer.

For example, in an embodiment of the present disclosure, the first partition portion 31 and the second partition portion 32 have a same structure, for example, both are protrusion portions or both are recessed portions.

Alternatively, in an embodiment of the present disclosure, the first partition portion 31 and the second partition portion 32 may have different structures, for example, one of the first partition portion 31 and the second partition portion 32 is a protrusion portion, and the other is a recessed portion.

In an embodiment of the present disclosure, as shown in FIG. 1, the first partition portion 31 includes a first notch 41, and the second partition portion 32 includes a second notch 42. That is, the first partition portion 31 is a non-closed structure including the first notch 41, and the second partition portion 32 is a non-closed structure including the second notch 42.

When the partition portion 3 is configured to include the protrusion portion 301 shown in FIG. 2 and FIG. 3 or the recessed portion 302 shown in FIG. 4 and FIG. 5, the expression "the first partition portion 31 includes a first notch 41" means that, at the first notch 41, the first partition portion 31 has an approximately flat structure without a protrusion or a recess. Moreover, the expression "the second partition portion 32 includes a second notch 42" means that, at the second notch 42, the second partition portion 32 has an approximately flat structure without a protrusion or a recess.

The provision of the first notch 41 and the second notch 42 prevents disconnection or thickness reduction of the second electrode 202-formed after the first partition portion 31 and the second partition portion 32-at the locations of the first notch 41 and the second notch 42, so that at the first notch 41 and the second notch 42, the second electrode 202 is formed as a continuous structure with a large thickness. As a result, a voltage drop of a signal transmitted through the second electrode 202 is reduced, improving the voltage uniformity of the second electrode 202 in the display region and the display uniformity of the display panel.

For example, as shown in FIG. 1, the display panel 100 further includes multiple support portions 5. In a third direction h13, at least some of the support portions 5 are each located between the first sub-pixel 21 and the adjacent second sub-pixel 22. In a fourth direction h14, at least some of the support portions 5 are each located between two adjacent third sub-pixels 23. Both the third direction h13 and the fourth direction h14 are parallel to the plane of the substrate 1, and the third direction h13 intersects both the first direction h11 and the second direction h12. The fourth direction h14 intersects both the first direction h11 and the second direction h12. The third direction h13 intersects the fourth direction h14. As schematically illustrated in FIG. 1, the third direction h13 is perpendicular to the fourth direction h14.

In an implementation, the support portion 5 is configured to support a mask used in the fabrication of the display panel 100.

For example, as shown in FIG. 6, which is a schematic diagram of a cross-section of a first sub-pixel, a second sub-pixel and a support portion according to an embodiment of the present disclosure, in the third direction h13, the support portion 5 is located between the first sub-pixel 21 and the second sub-pixel 22. In a direction h2 perpendicular to the plane of the substrate 1, the support portion 5 protrudes from the top surface of the pixel-defining layer 8 away from the substrate 1. For example, when the partition portion 3 is configured to include the protrusion portion 301 shown in FIG. 2 and FIG. 3, as shown in FIG. 6 and FIG. 3, a height H5 of the support portion 5 is greater than or equal to a height H301 of the protrusion portion 301.

In an optional implementation, as shown in FIG. 6, the support portion 5 includes a third side surface S51 and a third bottom surface S52 close to the substrate 1. In an embodiment of the present disclosure, an included angle, oriented toward the interior of the support portion 5, between the third side surface S51 and the third bottom surface S52 is an acute angle, i.e., a top surface of the support portion 5 has a smaller area than the bottom surface. The common layer 204 formed after the support portion 5 is formed on the third side surface S51.

In an embodiment of the present disclosure, at least one of a non-notch portion of the first partition portion 31, a non-notch portion of the second partition portion 32 or the support portion 5 is provided between adjacent first sub-pixel 21 and second sub-pixel 22. The region "between adjacent first sub-pixel 21 and second sub-pixel 22" refers to a region defined by a quadrilateral, which is determined by two vertices of the first sub-pixel 21 and two vertices of the adjacent second sub-pixel 22. The two vertices of the first sub-pixel 21 are two vertices of multiple vertices of the first sub-pixel 21 that are farthest apart in a direction intersecting an arrangement direction of the first sub-pixel 21 and the second sub-pixel 22. The two vertices of the second sub-pixel 22 are two vertices of multiple vertices of the second sub-pixel 22 that are farthest apart in the direction intersecting the arrangement direction of the first sub-pixel 21 and the second sub-pixel 22.

For example, as shown in FIG. 1, between a particular pair of first sub-pixel 21 and second sub-pixel 22 adjacent to each other in the third direction h13, the first notch 41, the second notch 42 and the support portion 5 are included. That is, among the non-notch portion of the first partition portion 31, the non-notch portion of the second partition portion 32 and the support portion 5, only the support portion 5 is provided between the particular pair of first sub-pixel 21 and second sub-pixel 22. The expression "between a particular pair of first sub-pixel 21 and second sub-pixel 22 adjacent to each other in the third direction h13, the first notch 41, the second notch 42 and the support portion 5 are included" means that the first notch 41, the second notch 42 and the support portion 5 are located within a first region AA1, where the first region AA1 has a quadrilateral shape, with four vertices-the two vertices of the first sub-pixel 21 and the two vertices of the second sub-pixel 22. The two vertices of the first sub-pixel 21 are two vertices of four vertices of the first sub-pixel 21 that are farthest apart in the fourth direction h14, and the two vertices of the second sub-pixel 22 are two vertices of four vertices of the second sub-pixel 22 that are farthest apart in the fourth direction h14. FIG. 1 illustrates an outline of the first region AA1 with dotted lines.

Between another pair of first sub-pixel 21 and second sub-pixel 22 adjacent to each other in the third direction h13, neither the support portion 5 nor the non-notch portion of the first partition portion 31 is included, but only the non-notch portion of the second partition portion 32 is included.

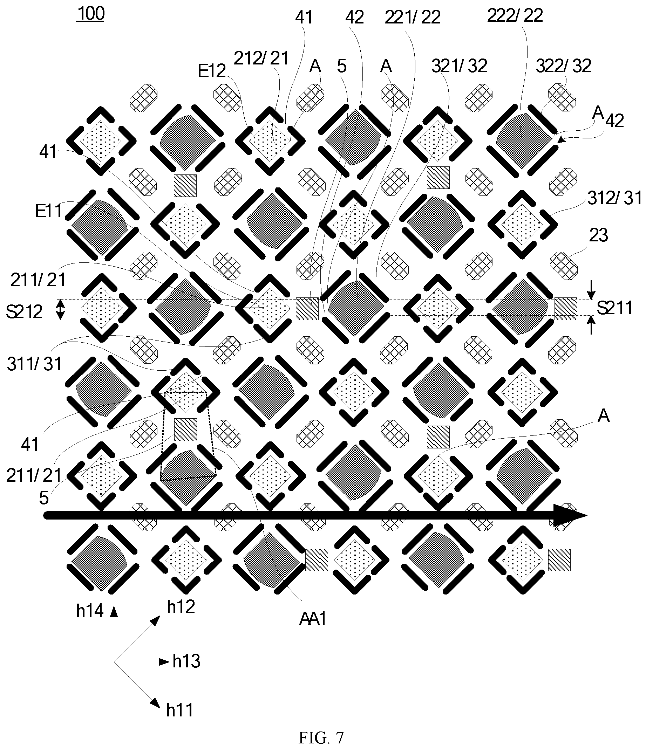

In another optional implementation, as shown in FIG. 7, which is a schematic diagram of a display panel according to another embodiment of the present disclosure, between a particular pair of first sub-pixel 21 and second sub-pixel 22 adjacent to each other in the third direction h13, the first notch 41, the second notch 42 and the support portion 5 are included. That is, only the support portion 5 is provided between the particular pair.

Between another pair of first sub-pixel 21 and second sub-pixel 22 adjacent to each other in the third direction h13, neither the support portion 5 nor the non-notch portion of the second partition portion 32 is included, but only the non-notch portion of the first partition portion 31 is included.

Between a particular pair of first sub-pixel 21 and second sub-pixel 22 adjacent to each other in the fourth direction h14, the first notch 41, the second notch 42 and the support portion 5 are included. That is, only the support portion 5 is provided between the particular pair. The expression "between a particular pair of first sub-pixel 21 and second sub-pixel 22 adjacent to each other in the fourth direction h14, the first notch 41, the second notch 42 and the support portion 5 are included" means that the first notch 41, the second notch 42 and the support portion 5 are located within a first region AA1, where the first region AA1 has a quadrilateral shape, with four vertices-the two vertices of the first sub-pixel 21 and the two vertices of the second sub-pixel 22. The two vertices of the first sub-pixel 21 are two vertices of four vertices of the first sub-pixel 21 that are farthest apart in the third direction h13, and the two vertices of the second sub-pixel 22 are two vertices of four vertices of the second sub-pixel 22 that are farthest apart in the third direction h13. FIG. 7 illustrates an outline of the first region AA1 with dotted lines.

Between another pair of first sub-pixel 21 and second sub-pixel 22 adjacent to each other in the fourth direction h14, neither the support portion 5 nor the non-notch portion of the second partition portion 32 is included, that is, only the non-notch portion of the first partition portion 31 is provided.

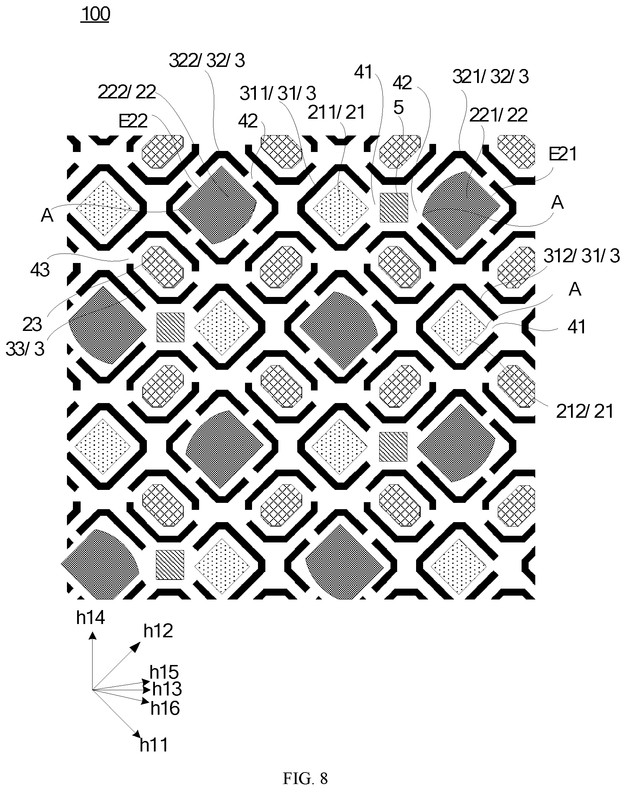

In yet another optional implementation, as shown in FIG. 8, which is a schematic diagram of a display panel according to yet another embodiment of the present disclosure, between a particular pair of first sub-pixel 21 and second sub-pixel 22 adjacent to each other in the third direction h13, the first notch 41, the second notch 42 and the support portion 5 are included. That is, only the support portion 5 is provided between the particular pair.

Between another pair of first sub-pixel 21 and second sub-pixel 22 adjacent to each other in the third direction h13, the support portion 5 is not included, but both the non-notch portion of the second partition portion 32 and the non-notch portion of the first partition portion 31 are included.

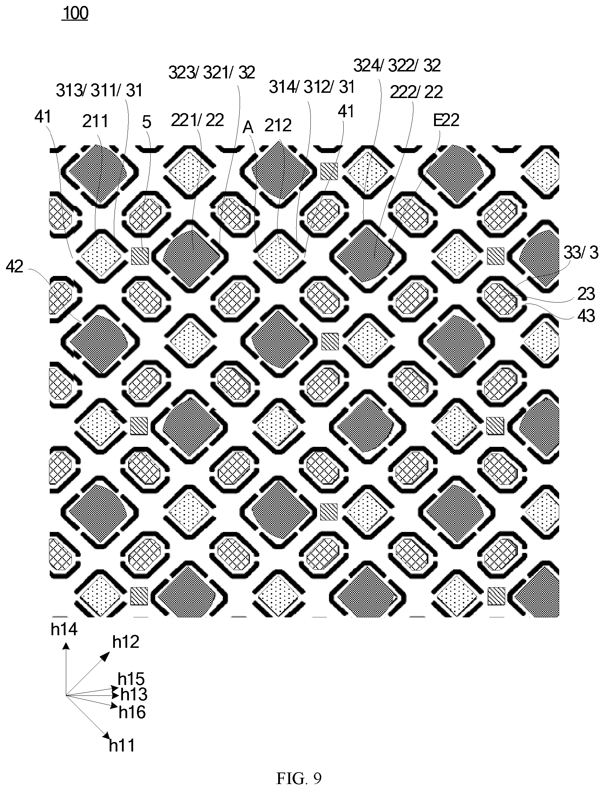

In yet another optional implementation, as shown in FIG. 9, which is a schematic diagram of a display panel according to yet another embodiment of the present disclosure, between a particular pair of first sub-pixel 21 and second sub-pixel 22 adjacent to each other in the third direction h13, the first notch 41, the non-notch portion of the second partition portion 32 and the support portion 5 are included. That is, only both the non-notch portion of the second partition portion 32 and the support portion 5 are provided between the particular pair.

Between another pair of first sub-pixel 21 and second sub-pixel 22 adjacent to each other in the third direction h13, neither the support portion 5 nor the non-notch portion of the first partition portion 31 is included, but only the non-notch portion of the second partition portion 32 is included.

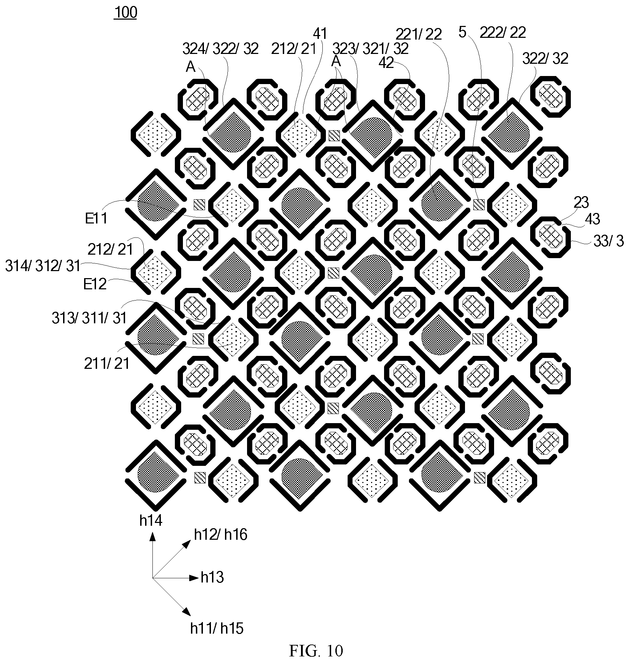

In yet another optional implementation, as shown in FIG. 10, which is a schematic diagram of a display panel according to yet another embodiment of the present disclosure, between a particular pair of first sub-pixel 21 and second sub-pixel 22 adjacent to each other in the third direction h13, the second notch 42, the non-notch portion of the first partition portion 31 and the support portion 5 are included. That is, only both the non-notch portion of the first partition portion 31 and the support portion 5 are provided between the particular pair. Between another pair of first sub-pixel 21 and second sub-pixel 22 adjacent to each other in the third direction h13, neither the support portion 5 nor the non-notch portion of the second partition portion 32 is included, but only the non-notch portion of the first partition portion 31 is included.

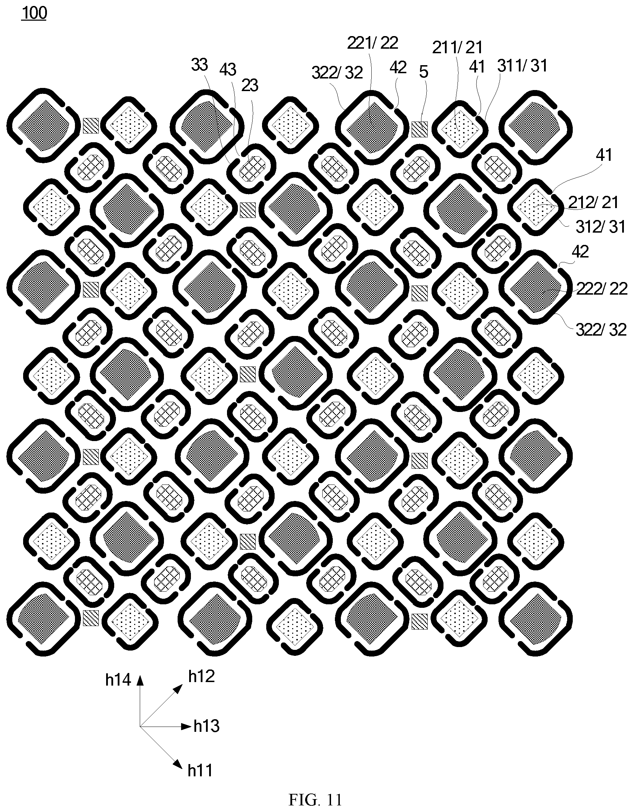

In yet another optional implementation, as shown in FIG. 11, which is a schematic diagram of a display panel according to yet another embodiment of the present disclosure, between a particular pair of first sub-pixel 21 and second sub-pixel 22 adjacent to each other in the third direction h13, the non-notch portion of the first partition portion 31, the non-notch portion of the second partition portion 32 and the support portion 5 are included. Between another pair of first sub-pixel 21 and second sub-pixel 22 adjacent to each other in the third direction h13, the support portion 5 is not included, but only both the non-notch portion of the second partition portion 32 and the non-notch portion of the first partition portion 31 are included.

As described above, the provision of the first notch 41 and the second notch 42 prevents the second electrode 202 from having defects such as thickness reduction and breakage at the locations of the first notch 41 and the second notch 42, which improves the connection reliability of the second electrode 202.

In the embodiments of the present disclosure, when providing the first notch 41, the second notch 42 and the support portion 5, by providing at least one of the non-notch portion of the first partition portion 31, the non-notch portion of the second partition portion 32 or the support portion 5 between adjacent first sub-pixel 21 and second sub-pixel 22, the positions of the first notch 41, the second notch 42 and the support portion 5 are comprehensively considered, while ensuring the connection reliability of the second electrode 202. This avoids the provision of both the first notch and the second notch between the first sub-pixel and the second sub-pixel, neither of which is adjacent to the support portion. It is ensured that at least one suppression structure for extending or blocking the conduction path of the lateral leakage current is provided between the first sub-pixel 21 and the second sub-pixel 22 that are not adjacent to the support portion 5, to suppress the flow of the lateral leakage current between the first sub-pixel 21 and the second sub-pixel 22. As a result, the possibility of crosstalk between the first sub-pixel 21 and the second sub-pixel 22 is reduced, reducing the possibility of unintended light emission of the first sub-pixel 21 and the second sub-pixel 22, optimizing low-gray-scale display performance of the display panel, and improving display quality of the display panel. For example, when the first sub-pixel 21 is a red sub-pixel and the second sub-pixel 22 is a blue sub-pixel, based on the above arrangement provided by the embodiments of the present disclosure, when displaying a blue image, the possibility of unintended light emission of the red sub-pixel is reduced, thereby improving the display quality of the blue image.

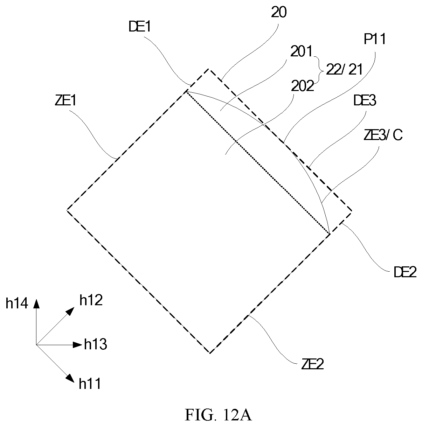

In an embodiment of the present disclosure, as shown in FIG. 1 and FIG. 12A, with FIG. 12A being an enlarged schematic diagram of a sub-pixel including a protrusion portion and a body portion according to an embodiment of the present disclosure, at least one of the first sub-pixel 21 or the second sub-pixel 22 includes a protrusion portion 201 and a body portion 202. An edge of the protrusion portion 201 away from the body portion 202 includes an arc C protruding away from the body portion 202.

FIG. 1, FIG. 7, FIG. 8, FIG. 9, FIG. 10 and FIG. 11 schematically show that the second sub-pixel 22 is configured to include the protrusion portion 201 and the body portion 202.

As shown in FIG. 12A, the second sub-pixel 22 has a virtual circumscribed quadrilateral 20. The virtual circumscribed quadrilateral 20 includes a first virtual side DE1, a second virtual side DE2, a third virtual side DE3 and a fourth virtual side DE4. The third virtual side DE3 is connected to the first virtual side DE1 at one end and to the second virtual side DE2 at the other end, and the fourth virtual side DE4 and the third virtual side DE3 face each other. The first virtual side DE1, the second virtual side DE2, the third virtual side DE3, and the fourth virtual side DE4 are all straight segments.

For example, as shown in FIG. 12A, the body portion 202 includes a first edge ZE1 and a second edge ZE2. The protrusion portion 201 includes a third edge ZE3, which includes the above arc C.

In an embodiment of the present disclosure, the first virtual side DE1 partially coincides with the first edge ZE1, that is, at least one point on the first edge ZE1 is located on the first virtual side DE1. In an embodiment as shown in FIG. 12A, all points on the first edge ZE1 are located on the first virtual side DE1.

The second virtual side DE2 partially coincides with the second edge ZE2, that is, at least one point on the second edge ZE2 is located on the second virtual side DE2. In an embodiment as shown in FIG. 12A, all points on the second edge ZE2 are located on the second virtual side DE2.

At least one point on the third edge ZE3 coincides with the third virtual side DE3. As shown in FIG. 12A, the third edge ZE3 is tangent to the third virtual side DE3 at a first point P11.

Based on this arrangement, an orthographic projection of at least one of the first sub-pixel 21 or the second sub-pixel 22 onto the plane of the substrate 1 is located within the corresponding virtual circumscribed quadrilateral 20.

It should be noted that the shape of each sub-pixel referred to in the embodiments of the present disclosure refers to the shape of the opening 80 formed in the pixel-defining layer 8. For example, as shown in FIG. 2, when the opening 80 is provided such that the area of the side away from the substrate 1 is greater than the area of the side close to the substrate 1, the shape of each sub-pixel refers to the shape of a region corresponding to a lower edge of the opening 80, i.e., the shape of a region of the light-emitting layer in contact with the first electrode 201, which is the shape of a light-emitting region of the sub-pixel.

Compared with a case where the shape of either the first sub-pixel 21 or the second sub-pixel 22 is provided to be its corresponding virtual circumscribed quadrilateral, in the embodiments of the present disclosure, by configuring at least one of the first sub-pixel 21 or the second sub-pixel 22 to include the protrusion portion 201 and the body portion 202 and configuring the edge of the protrusion portion 201 away from the body portion 202 to include the arc C, an area of the at least one sub-pixel is reduced. For example, when the first sub-pixel 21 is provided to include the protrusion portion, the area of the first sub-pixels 21 is reduced; when the second sub-pixel 22 is provided to include the protrusion portion, the area of the second sub-pixels 22 is reduced; and when both the first sub-pixel 21 and the second sub-pixel 22 are provided to include the protrusion portion 201, the area of the first sub-pixel 21 and the area of the second sub-pixel 22 are reduced. The area saved by the protrusion portion 201 relative to the virtual circumscribed quadrilateral corresponding to the sub-pixel 2 constitutes the area reduction. When the area of the sub-pixel 2 is reduced, a distance between the sub-pixel 2 and another adjacent sub-pixel 2 is increased. This distance increase provides two benefits: first, it extends a flow path of the lateral leakage current between these two sub-pixels 2, thereby reducing crosstalk; and second, it leaves more room for providing the first partition portion 31, the second partition portion 32 and the support portion 5, thereby reducing the difficulty in providing the first partition portion 31, the second partition portion 32 and/or the support portion 5 between these two sub-pixels. For example, the partition portion 3 and the support portion 5 are each separated from the first sub-pixel 21 and the second sub-pixel 22 by a preset distance, to prevent the partition portion 3 or the support portion 5 from being located in the opening of the sub-pixel due to process errors or subsequent external forces, and avoid display degradation.

On the other hand, while ensuring that a minimum spacing between two adjacent sub-pixels remains unchanged, in the embodiments of the present disclosure, either the first sub-pixel 21 or the second sub-pixel 22 is configured to include the protrusion portion, which is equivalent to modifying the virtual circumscribed quadrilateral corresponding to the first sub-pixel 21 or the second sub-pixel 22 by replacing its corresponding edge with an arc edge, as compared to a configuration in which either the first sub-pixel 21 or the second sub-pixel 22 has a square shape. Taking the modification of the virtual circumscribed quadrilateral corresponding to the second sub-pixel 22 by replacing its corresponding edge with an arc edge as an example, this is equivalent to causing at least one corner of the second sub-pixel 22 to recede inward toward the center of the virtual circumscribed quadrilateral. This creates additional space to allow another sub-pixel adjacent to the second sub-pixel 22 to expand outward, thereby increasing the area of the expanded sub-pixel and improving its aperture ratio.

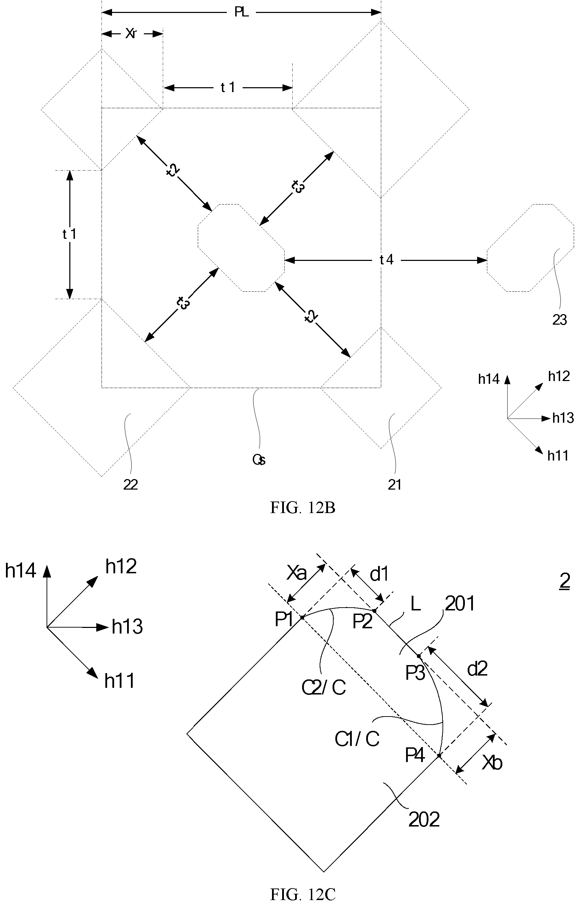

In an implementation, referring to FIG. 12B, which is a schematic diagram of a display panel in the related art, the shapes of both the first sub-pixel 21 and the second sub-pixel 22 are square. The first sub-pixel 21 and the second sub-pixel 22 are alternately arranged in both the third direction h13 and the fourth direction h14. The centers (i.e., centers of gravity) of two first sub-pixels 21 and two second sub-pixels 22 that are adjacent constitute a virtual square Qs. One third sub-pixel 23 is located in the virtual square Qs, and the center (i.e., centroid) of the third sub-pixel 23 coincides with the center of the virtual square Qs.

For example, assuming that a pixel pitch PL between the first sub-pixel 21 and the second sub-pixel 22 is 55µm, a minimum opening spacing t1 between the first sub-pixel 21 and the second sub-pixel 22 is 25µm, a minimum opening spacing t2 between the third sub-pixel 23 and the first sub-pixel 21 is 18µm, a minimum opening spacing t3 between the third sub-pixel 23 and the second sub-pixel 22 is 18µm, a minimum opening spacing t4 between two adjacent third sub-pixels 23 is 35µm, and a distance Xr from the vertex to the center of the first sub-pixel 21 is 10.98µm, it is calculated that an area S1 of the first sub-pixel 21 is 241.12µm², an area S2 of the second sub-pixel 22 is 723.52µm², and an area S3 of the third sub-pixel 23 is 308.15µm². For a pixel unit including one first sub-pixel 21, one second sub-pixel 22 and two third sub-pixels 23, a total opening area of the pixel unit is S_total=S1+S2+2S3=1580.94µm².

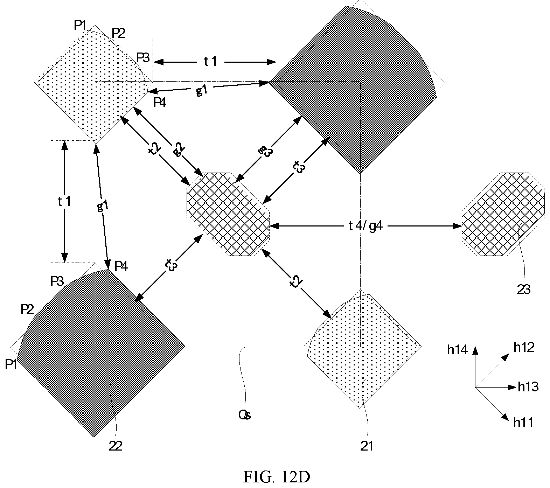

Referring to FIG. 12C and FIG. 12D, FIG. 12C is an enlarged schematic diagram of a sub-pixel including a protrusion portion and a body portion according to another embodiment of the present disclosure, FIG. 12D is a schematic diagram of a comparison between a display panel according to an embodiment of the present disclosure and the display panel in the related art shown in FIG. 12B, and the shapes of both the first sub-pixel 21 and the second sub-pixel 22 in FIG. 12D are designed based on the sub-pixel shape in FIG. 12C. The sub-pixel includes the protrusion portion 201 and the body portion 202. The arc C includes a first arc C1 and a second arc C2. The edge of the protrusion portion 201 away from the body portion 202 further includes a straight segment L connecting the first arc C1 and the second arc C2. A length of the first arc C1 is greater than a length of the second arc C2. Two endpoints of the first arc C1 are P3 and P4, two endpoints of the second arc C2 are P1 and P2, and two endpoints of the straight segment L are P2 and P3.

In FIG. 12D, a minimum opening spacing g1 between the first sub-pixel 21 and the second sub-pixel 22 is 25µm, a minimum opening spacing g2 between the third sub-pixel 23 and the first sub-pixel 21 is 18µm, a minimum opening spacing g3 between the third sub-pixel 23 and the second sub-pixel 22 is 18µm, and a minimum opening spacing g4 between two adjacent third sub-pixels 23 is 35µm. That is, the minimum opening spacing between any two of the first sub-pixel 21, the second sub-pixel 22 and the third sub-pixel 23, as well as the minimum opening spacing between two adjacent third sub-pixels 23 in the embodiment of the present disclosure, are respectively set to be equal to the corresponding minimum opening spacing in the related art.

It should be noted that, in the related art, since both the first sub-pixel 21 and the second sub-pixel 22 are square, the minimum opening spacing between them is the distance along the line connecting the centers of the sub-pixels (the side of the virtual square Qs). In an embodiment of the present disclosure, when the first sub-pixel 21 and the second sub-pixel 22 are configured to include the above protrusion portion 201 in the manner shown in FIG. 12A and FIG. 12C, the minimum opening spacing g1 between the first sub-pixel 21 and the second sub-pixel 22 is not equal to the distance between the first sub-pixel 21 and the second sub-pixel 22 along the side of the virtual square Qs. For example, as shown in FIG. 12C and FIG. 12D, the minimum opening spacing g1 between the first sub-pixel 21 and the second sub-pixel 22, which are adjacent in the third direction h13, is the distance between the point P4 of the first sub-pixel 21 and the nearest right-angled vertex of the second sub-pixel 22. The minimum opening spacing g1 between the first sub-pixel 21 and the second sub-pixel 22, which are adjacent in the fourth direction h14, is the distance between the point P4 of the second sub-pixel 22 and the nearest right-angled vertex of the first sub-pixel 21. The same applies to the minimum opening spacing between any other adjacent first sub-pixel 21 and second sub-pixel 22, and thus no further details are provided.

For example, assuming that in FIG. 12C, for the first sub-pixel 21, Xa=Xb=2.8µm, and a length of the straight segment L from P2 to P3 is 5µm, and for the second sub-pixel 22, Xa=Xb=2.7µm, and a length of the straight segment L from P2 to P3 is 6µm, it is calculated that S1=261.56µm², S2=799.45µm², S3=279.84µm², and the total opening area of the pixel unit is S_total=S1+S2+2S3=1620.69µm².

Thus, on the basis that the minimum spacing between any two adjacent sub-pixels is consistent with that in the related art shown in FIG. 12B, by using the arrangement provided by the embodiment of the present disclosure, the areas and the aperture ratios of the first sub-pixel 21 and the second sub-pixel 22 are increased, and the total aperture ratio of the pixel unit including one first sub-pixel 21, one second sub-pixel 22 and two third sub-pixels 23 is also improved, as compared to a case where both the first sub-pixel 21 and the second sub-pixel 22 are configured to be square.

In addition, in the embodiment of the present disclosure, the design of the third sub-pixel 23 is affected not only by the above g2 and g3, but also by the mask opening spacing of the fine metal mask (FMM). The mask opening spacing of the fine metal mask is also referred to as the rib width of the fine metal mask. In order to ensure the strength of the fine metal mask, the spacing between mask openings is limited, and thus the distance between two adjacent third sub-pixels 23 in the third direction h13 and the distance between two adjacent third sub-pixels 23 in the fourth direction h14 are also limited. The distances are not reduced due to the outward expansion of the first sub-pixel 21 and the second sub-pixel 22. That is, compared with the related art, in the embodiment of the present disclosure, opposite edges of the third sub-pixel 23 in the third direction h13 and in the fourth direction h14 do not move inward. Therefore, even if it is ensured that the minimum opening spacing g2 between the third sub-pixel 23 and the first sub-pixel 21 and the minimum opening spacing g3 between the third sub-pixel 23 and the second sub-pixel 22 respectively satisfy g2≥t2 and g3≥t3, when the first sub-pixel 21 and the second sub-pixel 22 are expanded outward, at least some of the edges of the third sub-pixel 23, which is located within the virtual square Qs, may undergo inward displacement, reducing the opening area of the third sub-pixel 23. However, based on the arrangement provided by the embodiment of the present disclosure, the inward displacement of the opposite edges of the third sub-pixel 23 in the third direction h13 and in the fourth direction h14 is avoided, thereby preventing the opening area of the third sub-pixel 23 from being too small, and ensuring that the total aperture ratio of the pixel unit including one first sub-pixel 21, one second sub-pixel 22 and two third sub-pixels 23 is increased relative to the related art.

In view of the above, compared with the related art, the pixel design according to the embodiments of the present disclosure increases the total aperture ratio of the pixel unit including one first sub-pixel 21, one second sub-pixel 22, and two third sub-pixels 23, without increasing the process difficulty, such as when the relevant process parameters (such as the minimum opening spacing between adjacent sub-pixels, FMM rib width, etc.) are consistent with those in the prior art or have additional design margin. Such improvement enhances the display effect and the display quality of the display panel.

For example, as shown in FIG. 1, FIG. 7, FIG. 8, FIG. 9, FIG. 10 and FIG. 11, the first sub-pixel 21 includes a first first sub-pixel 211, and the support portion 5 is located between the first first sub-pixel 211 and the second sub-pixel 22.

As shown in FIG. 1, FIG. 7, FIG. 8, FIG. 9, FIG. 10 and FIG. 11, in the third direction h13, at least some of the support portions 5 are each located between the first first sub-pixel 211 and the second sub-pixel 22. As shown in FIG. 7, in the fourth direction h14, some of the support portions 5 are each located between the first first sub-pixel 211 and the second sub-pixel 22.

The first first sub-pixel 211 includes a vertex angle A, which is formed by two adjacent edges of the first first sub-pixel 211. Any one of the two adjacent edges may be a straight segment or an arc. FIG. 1, FIG. 7, FIG. 8, FIG. 9, FIG. 10, and FIG. 11 schematically show that all the edges of the first first sub-pixel 211 are straight segments.

In an embodiment of the present disclosure, the first partition portion 31 includes a first partition sub-portion 311 at least partially surrounding the first first sub-pixel 211.

In an implementation, as shown in FIG. 1, FIG. 7, FIG. 8, FIG. 9 and FIG. 10, the first partition sub-portion 311 includes the first notch 41 corresponding to the vertex angle A of the first first sub-pixel 211. The expression "the first notch 41 corresponding to the vertex angle A of the first first sub-pixel 211" means that a line connecting a center of the first notch 41 and the centroid of the virtual circumscribed quadrilateral of the first first sub-pixel 211 passes through the vertex angle A. The center of the first notch 41 refers to a midpoint of a connecting line between two endpoints of the first partition portion 31 that define the first notch 41.

In an embodiment of the present disclosure, the first notch 41 is provided corresponding to the vertex angle A of the first first sub-pixel 211, such that the second electrode 202 has increased thickness at the periphery of the vertex angle A, and thus the second electrode 202 of the first first sub-pixel 211 has a good connection at the periphery of the vertex angle A.

Moreover, when the distance between adjacent first first sub-pixel 211 and second sub-pixel 22 is fixed, since the first first sub-pixel 211 is disposed close to the support portion 5, the space for disposing the support portion 5 is increased by forming the first notch 41 corresponding to the vertex angle A, i.e., by omitting the first partition sub-portion 311 at the first notch 41, thereby reducing the difficulty in disposing the support portion 5.

It should be understood that the centroid of the virtual circumscribed quadrilateral mentioned in the embodiments of the present disclosure is defined as the center of mass of the virtual circumscribed quadrilateral, that is, the centroid. If the virtual circumscribed quadrilateral has a regular geometric shape, the geometric center of the virtual circumscribed quadrilateral coincides with its centroid. For example, if the virtual circumscribed quadrilateral is a parallelogram, the intersection point of the two diagonal lines of the parallelogram is both its geometric center and its centroid. If the virtual circumscribed quadrilateral has an asymmetric and irregular geometric shape, its centroid can be determined by related technologies, but it is difficult to determine the geometric center thereof. In this case, it is difficult to determine the relative positional relationship between the geometric center and the centroid of the virtual circumscribed quadrilateral.

It should be noted that a regular pattern (regular geometric shape) in the present disclosure satisfies at least one of the following conditions: 1) it is a centrosymmetric pattern; and 2) it is an axisymmetric pattern having more than two symmetry axes. Examples of regular patterns include an ellipse, a parallelogram (which is neither a rectangle nor a rhombus), a circle, a rounded rectangle, a regular polygon, a rectangle, and a rhombus. For a centrosymmetric pattern, its center of symmetry is its center (centroid); and for an axisymmetric pattern having more than two symmetry axes, the intersection point of its two symmetry axes is its center (centroid). In addition, a pattern other than the regular pattern is an irregular pattern.

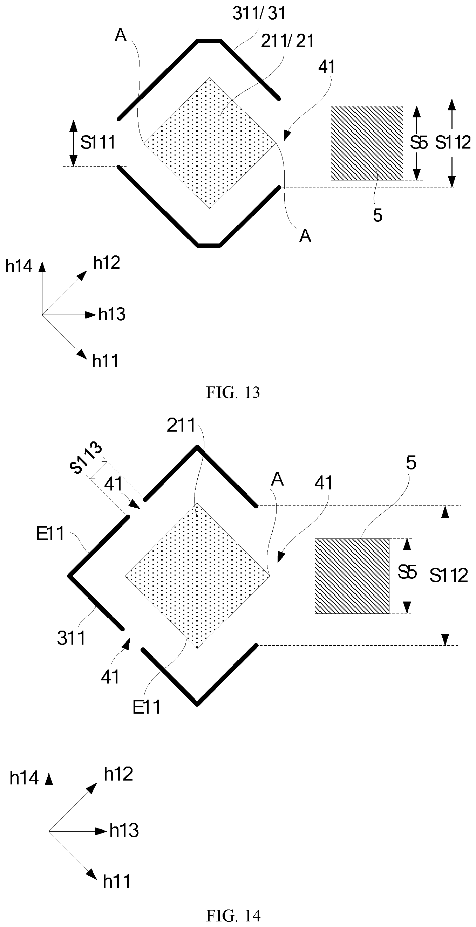

For example, as shown in FIG. 13, which is an enlarged schematic diagram of a first first sub-pixel, a first partition portion and a support portion according to an embodiment of the present disclosure, the first first sub-pixel 211 includes at least two vertex angles A. FIG. 13 schematically shows that the first first sub-pixel 211 has a quadrilateral shape, where two adjacent edges of the first first sub-pixel 211 intersect to form the vertex angle A. In the implementation shown in FIG. 13, the first first sub-pixel 211 includes four vertex angles A. The first partition sub-portion 311 includes at least two first notches 41, and the two first notches 41 each correspond to a different vertex angle A. In the third direction h13, one of the two first notches 41 is located at a side of the first first sub-pixel 211 close to the support portion 5, and the other of the two first notches 41 is located at a side of the first first sub-pixel 211 away from the support portion 5. That is, the two first notches 41 and the support portion 5 are arranged along the third direction h13. As shown in FIG. 13, a line connecting the centroid of the virtual circumscribed quadrilateral of the first first sub-pixel 211 and the centroid of the support portion 5 passes through the two first notches 41.

The first notch 41 disposed close to the support portion 5 prevents the provision of the protrusion portion or the recessed portion at the periphery of the vertex angle A of the first first sub-pixel 211 close to the support portion 5, thereby preventing the protrusion portion or the recessed portion from occupying the space for the support portion 5, and reducing the difficulty in disposing the support portion 5. Moreover, the disposition of the first notch 41 away from the support portion 5 increases the number of first notches 41, thereby providing more reliable connection positions for the second electrode and increasing the number of conduction paths for the signal transmitted by the second electrode. For example, at least along the arrangement direction of the two first notches 41, a signal is smoothly transmitted by the second electrode.

In an implementation, as shown in FIG. 13, a length of the first notch 41 away from the support portion 5 is S111, and a length of the first notch 41 close to the support portion 5 is S112, where S111≤S112. Based on this arrangement, by making the length of the first notch 41 close to the support portion 5 larger, the distance between the support portion 5 and the non-notch portion of the first partition sub-portion 311 is increased, thereby further reducing the difficulty in disposing the support portion 5.

For example, as shown in FIG. 13, a length of the support portion 5 in the fourth direction h14 is S5, where S111≤S5≤S112. In this way, the distance between the support portion 5 and the first first sub-pixel 211 is reduced, while the mutual influence between the first partition sub-portion 311 and the support portion 5 is avoided. For example, the area of the first first sub-pixel 211 can be set as large as possible to increase the aperture ratio of the first first sub-pixel 211 and avoid driving the first first sub-pixel 211 to display with an excessive current density. This prolongs the service life of the first first sub-pixel 211 and improves the display effect of the display panel 100.

For example, as shown in FIG. 7 and FIG. 14, with FIG. 14 being an enlarged schematic diagram of a first first sub-pixel, a first partition portion and a support portion according to another embodiment of the present disclosure, the first first sub-pixel 211 further includes multiple first first edges E11. Two adjacent first first edges E11 form the vertex angle A of the first first sub-pixel 211. The first partition sub-portion 311 further includes a first notch 41 corresponding to one of the first first edges E11. The expression "a first notch 41 corresponding to one of the first first edges E11" means that a line connecting the center of the first notch 41 and the centroid of the virtual circumscribed quadrilateral of the first first sub-pixel 211 passes through the first first edge E11.

On the basis of providing the first notch 41 corresponding to the vertex angle A, the provision of the first notch 41 corresponding to the first first edge E11 further increases the number of first notches 41 in the first partition sub-portion 311, thereby improving the reliability of the second electrode provided corresponding to the first first edge E11, increasing the number of reliable conduction paths for the signal transmitted by the second electrode, reducing the voltage drop of the signal and improving the display uniformity. FIG. 14 schematically shows that the first partition sub-portion 311 is provided with two first notches 41 corresponding to their respective first first edges E11 and one first notch 41 corresponding to the vertex angle A.

In an embodiment of the present disclosure, as shown in FIG. 14, a length of the first notch 41 corresponding to the first first edge E11 is S113, and a length of the first notch 41 corresponding to the vertex angle A of the first first sub-pixel 211 and close to the support portion 5 is S112, where S113≤S112. Based on this arrangement, by making the length of the first notch 41 close to the support portion 5 larger, the distance between the support portion 5 and the non-notch portion of the first partition sub-portion 311 is increased, thereby further reducing the difficulty in disposing the support portion 5. In addition, in an embodiment of the present disclosure, by making the length of the first notch 41 corresponding to the first first edge E11 as small as possible, the area of the lateral leakage current region at the periphery of the first first sub-pixel 211 is reduced, thereby improving the reliability of the display panel.

For example, as shown in FIG. 14, a length of the support portion 5 in the fourth direction h14 is S5, where S113≤S5≤S112. Based on this arrangement, the distance between the support portion 5 and the first first sub-pixel 211 is reduced, while the mutual influence between the first partition sub-portion 311 and the support portion 5 is avoided. For example, the area of the first first sub-pixel 211 can be set as large as possible to increase the aperture ratio of the first first sub-pixel 211 and avoid driving the first first sub-pixel 211 to display with an excessive current density. This prolongs the service life of the first first sub-pixel 211 and improves the display effect of the display panel 100.

For example, as shown in FIG. 1, FIG. 7, FIG. 8, FIG. 9, FIG. 10 and FIG. 11, the first sub-pixel 21 includes a second first sub-pixel 212, and the support portion 5 is not provided between the second first sub-pixel 212 and the adjacent second sub-pixel 22. For example, no support portion 5 is provided between the second first sub-pixel 212 and the adjacent second sub-pixel 22 in the third direction h13, and no support portion 5 is provided between the second first sub-pixel 212 and the adjacent second sub-pixel 22 in the fourth direction h14.

For example, as shown in FIG. 1, FIG. 8, FIG. 9 and FIG. 10, the second first sub-pixel 212 includes a vertex angle A, and the first partition portion 31 includes a second partition sub-portion 312 at least partially surrounding the second first sub-pixel 212 and including the first notch 41 corresponding to the vertex angle A of the second first sub-pixel 212. The first notch 41 ensures the good connection of the second electrode located at the periphery of the vertex angle A of the second first sub-pixel 212.

For example, in an embodiment of the present disclosure, the second first sub-pixel 212 includes at least two vertex angles A, the second partition sub-portion 312 includes at least two first notches 41, and the two first notches 41 each correspond to a different vertex angle A. The two first notches 41 are located on two opposite sides of the second first sub-pixel 212 along either the third direction h13 or the fourth direction h14. FIG. 1 and FIG. 9 schematically show that the two first notches 41 are disposed on two opposite sides of the second first sub-pixel 212 along the third direction h13. FIG. 10 schematically shows that the two first notches 41 are disposed on two opposite sides of the second first sub-pixel 212 along the fourth direction h14.

In another optional implementation, as shown in FIG. 8, the first partition sub-portion 311 includes only one first notch 41 corresponding to the vertex angle A of the first first sub-pixel 211 and close to the support portion 5. Based on this arrangement, the number of the first notches 41 provided at the periphery of the first first sub-pixel 211 is reduced, which further reduces the possibility of unintended light emission of the first first sub-pixel 211. For example, in this case, in an embodiment of the present disclosure, only one first notch 41 corresponding to the vertex angle A of the second first sub-pixel 212 is provided in the second partition sub-portion 312.

In an embodiment of the present disclosure, the number and positional distribution of the first notches 41 at the peripheries of the first first sub-pixel 211 and the second first sub-pixel 212 are designed to be as consistent as possible, so that the lateral leakage current magnitudes at the peripheries become consistent, and the morphologies of the second electrodes of the first first sub-pixel 211 and the second first sub-pixel 212 also become consistent, thereby improving the luminescence consistency of the first first sub-pixel 211 and the second first sub-pixel 212 and enhancing the display uniformity of the display panel.

In an embodiment of the present disclosure, a length of the first notch 41 corresponding to the vertex angle A of the second first sub-pixel 212 is S121, and the length of the first notch 41 corresponding to the vertex angle A of the first first sub-pixel 211 and close to the support portion 5 is S112. When configuring the first notch 41 corresponding to the vertex angle A of the second first sub-pixel 212, S121 is set to be less than or equal to S112 (that is, S121≤S112). Since no support portion 5 is disposed at the periphery of the second first sub-pixel 212, more space is available for the first partition portion 31. Thus, the length of the first notch 41 corresponding to the vertex angle A of the second first sub-pixel 212 can be appropriately reduced, and without affecting the arrangement of the support portion 5, the area of the lateral leakage current region at the periphery of the second first sub-pixel 212 can be reduced, thereby improving the display effect of the display panel.

For example, as shown in FIG. 7, the second first sub-pixel 212 further includes multiple second first edges E12. Two adjacent second first edges E12 form the vertex angle A of the second first sub-pixel 212. The second partition sub-portion 312 further includes the first notch 41 corresponding to one of the second first edges E12.

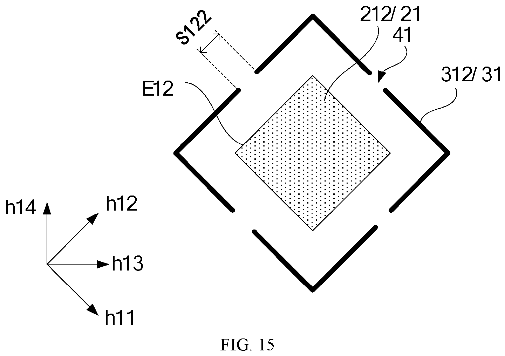

As shown in FIG. 7 and FIG. 15, with FIG. 15 being an enlarged schematic diagram of a second first sub-pixel and a first partition portion according to an embodiment of the present disclosure, a length of the first notch 41 corresponding to the second first edge E12 is S122. As shown in FIG. 14, the length of the first notch 41 corresponding to the vertex angle A of the first first sub-pixel 211 and close to the support portion 5 is S112, and in an embodiment of the present disclosure, S122≤S112. No support portion 5 is provided at the periphery of the second first sub-pixel 212. Therefore, in the embodiment of the present disclosure, by making the length of the first notch 41 corresponding to the second first edge E12 as small as possible, the area of the lateral leakage current region at the periphery of the second first sub-pixel 212 is reduced without affecting the arrangement of the support portion 5, thereby further improving the display effect of the display panel.

For example, further referring to FIG. 9 and FIG. 10, the first sub-pixel 21 includes the first first sub-pixel 211 and the second first sub-pixel 212. In the third direction h13 or the fourth direction h14, the support portion 5 is located between the first first sub-pixel 211 and the second sub-pixel 22, and no support portion 5 is provided between the second first sub-pixel 212 and the second sub-pixel 22. FIG. 9 and FIG. 10 schematically show that the support portion 5 is located between the first first sub-pixel 211 and the second sub-pixel 22 in the third direction h13.

As shown in FIG. 9 and FIG. 10, the first partition portion 31 includes a first first partition portion 313 and a second first partition portion 314. The first first partition portion 313 at least partially surrounds the first first sub-pixel 211, and the second first partition portion 314 at least partially surrounds the second first sub-pixel 212. For example, the first first partition portion 313 includes the first partition sub-portion 311, and the second first partition portion 314 includes the second partition sub-portion 312.

In an embodiment of the present disclosure, a shape of the first first partition portion 313 is the same as that of the second first partition portion 314, and a shape of the first notch 41 in the first first partition portion 313 is the same as that in the second first partition portion 314. A length of the first first partition portion 313 is the same as that of the second first partition portion 314, and a width of the first first partition portion 313 is the same as that of the second first partition portion 314. Length directions of the first first partition portion 313 and the second first partition portion 314 are parallel to their respective extension directions, and their width directions are perpendicular to their respective extension directions. A length of the first notch 41 in the first first partition portion 313 is the same as that in the second first partition portion 314. As shown in FIG. 9 and FIG. 10, the first first sub-pixel 211 can be made to coincide with the second first sub-pixel 212 by translation. The first first partition portion 313 can be made to coincide with the second first partition portion 314 by translation. The first notch 41 in the first first partition portion 313 can be made to coincide with the first notch 41 in the second first partition portion 314 by translation.

Based on this arrangement, the distributions of the first partition portions 31 and the first notches 41 at the peripheries of the first first sub-pixel 211 and the second first sub-pixel 212, which have different positional relationships with the support portion 5, can be made the same, so that the lateral leakage current magnitudes at the peripheries become consistent, and the morphologies of the second electrodes of the first first sub-pixel 211 and the second first sub-pixel 212 become consistent, thereby improving the display uniformity of the display panel.

In an implementation, as shown in FIG. 9, the first notch 41 in the first first partition portion 313 is disposed to correspond to the vertex angle A of the first first sub-pixel 211; the first notch 41 in the second first partition portion 314 is disposed to correspond to the vertex angle A of the second first sub-pixel 212; and along the third direction h13, two first notches 41 are located at two sides of the first first sub-pixel 211, and two first notches 41 are located at two sides of the second first sub-pixel 212.

In an implementation, as shown in FIG. 10, along the fourth direction h14, two first notches 41 are located at two sides of the first first sub-pixel 211, and two first notches 41 are located at two sides of the second first sub-pixel 212.

In an implementation, based on the arrangement shown in FIG. 10, the widths of the first first partition portion 313 and the second first partition portion 314 are appropriately reduced to avoid the mutual influence between the first first partition portion 313 and the support portion 5. For example, the widths W of the first first partition portion 313 and the second first partition portion 314 may satisfy 1.5µm≤W≤3.5µm.

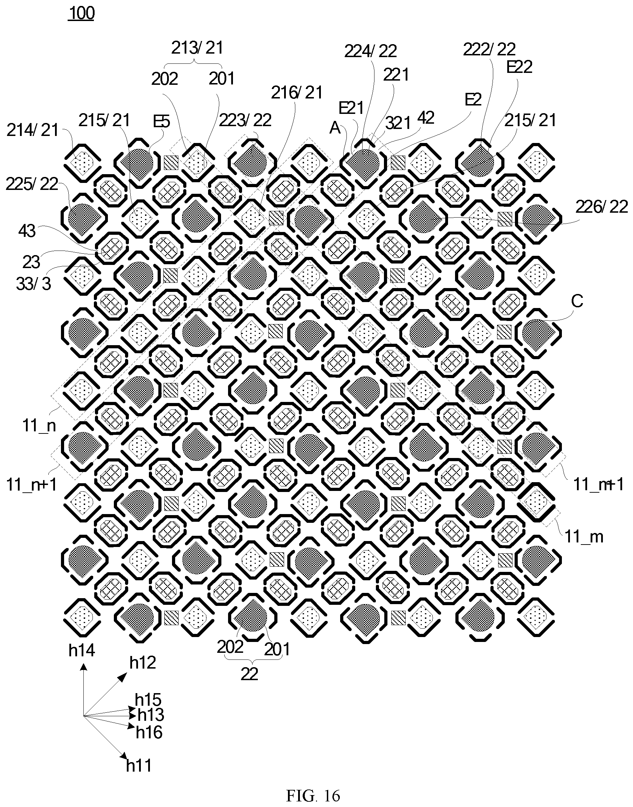

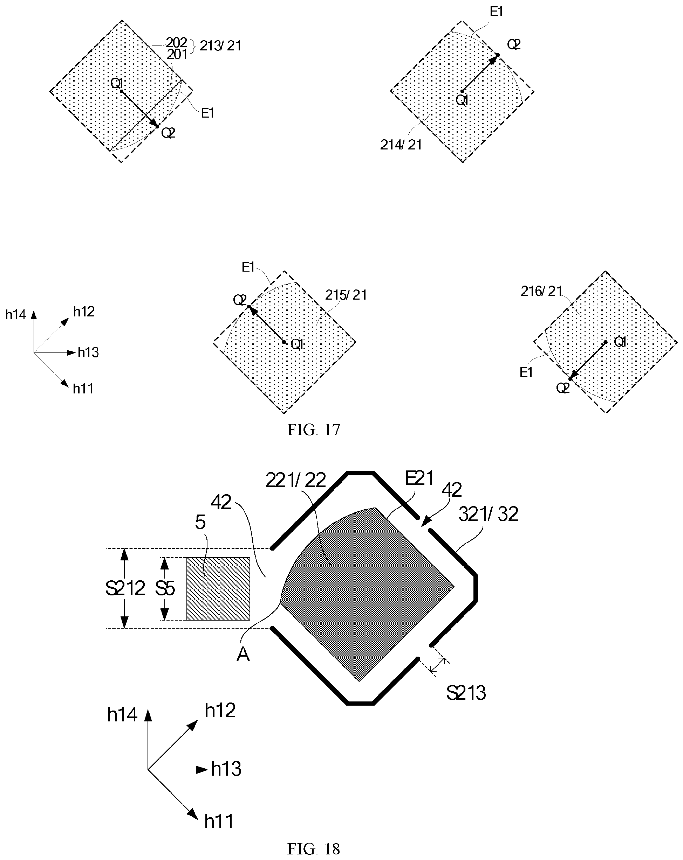

The above description is based on a configuration in which the first sub-pixel 21 is designed as a quadrilateral. In a further implementation, the first sub-pixel 21 may be configured to include the protrusion portion and the body portion. As shown in FIG. 16 and FIG. 17, with FIG. 16 being a schematic diagram of a display panel according to yet another embodiment of the present disclosure, and FIG. 17 being an enlarged schematic diagram of a first-type sub-pixel, a second-type sub-pixel, a third-type sub-pixel and a fourth-type sub-pixel in FIG. 16, the first sub-pixel 21 includes the protrusion portion 201 and the body portion 202. The protrusion portion 201 includes a first edge E1 away from the body portion 202, and the first edge E1 includes an arc C.

In the embodiment of the present disclosure, the first sub-pixel 21 has a virtual circumscribed quadrilateral. As shown in FIG. 17, the first sub-pixel 21 includes a first-type sub-pixel 213, a second-type sub-pixel 214, a third-type sub-pixel 215 and a fourth-type sub-pixel 216. A direction from a centroid Q1 of an orthographic projection of the virtual circumscribed quadrilateral of the first-type sub-pixel 213 onto the plane of the substrate 1 to a center Q2 of the first edge E1 is parallel to the first direction h11. A direction from a centroid Q1 of an orthographic projection of the virtual circumscribed quadrilateral of the second-type sub-pixel 214 onto the plane of the substrate 1 to a center Q2 of the first edge E1 is parallel to the second direction h12. A direction from a centroid Q1 of an orthographic projection of the virtual circumscribed quadrilateral of the third-type sub-pixel 215 onto the plane of the substrate 1 to a center Q2 of the first edge E1 is parallel to the direction opposite to the first direction h11. A direction from a centroid Q1 of an orthographic projection of the virtual circumscribed quadrilateral of the fourth-type sub-pixel 216 onto the plane of the substrate 1 to a center Q2 of the first edge E1 is parallel to the direction opposite to the second direction h12. The center of the first edge E1 refers to a midpoint of a connecting line between two endpoints of the first edge E1.

In an embodiment of the present disclosure, when arranging the first-type sub-pixel 213, the second-type sub-pixel 214, the third-type sub-pixel 215 and the fourth-type sub-pixel 216-for example, as shown in FIG. 16-in any row of sub-pixels (for example, an m-th row of the sub-pixels 11_m), the first-type sub-pixel 213, the third sub-pixel 23, the fourth-type sub-pixel 216, the third sub-pixel 23, the second-type sub-pixel 214, the third sub-pixel 23, the third-type sub-pixel 215, and the third sub-pixel 23 are alternately arranged in the above-listed sequence in the first direction h11.

For example, as shown in FIG. 16, for the m-th row of sub-pixels 11_m and the (m+2)-th row of sub-pixels 11_m+2, the fourth-type sub-pixels 216 in the m-th row are aligned with the second-type sub-pixels 214 in the (m+2)-th row in the second direction h12. The first-type sub-pixels 213 in the (m+2)-th row are aligned with the third-type sub-pixels 215 in the m-th row in the second direction h12. That is, in an embodiment of the present disclosure, in any column of sub-pixels (for example, in an n-th column of the sub-pixels 11_n), the second-type sub-pixel 214, the fourth-type sub-pixel 216, the first-type sub-pixel 213, and the third-type sub-pixel 215, are alternately arranged in the above-listed sequence in the second direction h12. Both m and n are positive integers. Based on this arrangement, the first sub-pixel 21 having differently oriented protrusion portions 201 is uniformly distributed in the display panel, thereby improving the display uniformity.

For example, as shown in FIG. 1, FIG. 7, FIG. 8, FIG. 9, FIG. 10, FIG. 11 and FIG. 16, the second sub-pixel 22 includes a first second sub-pixel 221. The support portion 5 is located between the first second sub-pixel 221 and the first sub-pixel 21. The first second sub-pixel 221 includes a vertex angle A. The vertex angle A of the first second sub-pixel 221 is formed by two adjacent edges of the second sub-pixel 22. In an embodiment of the present disclosure, any one of two adjacent edges of the second sub-pixel 22 may be a straight segment or an arc. FIG. 1, FIG. 7, FIG. 8, FIG. 9, FIG. 10, FIG. 11 and FIG. 16 schematically show that the edges of the second sub-pixel 22 include one arc and three straight segments. The second partition portion 32 includes a third partition sub-portion 321 at least partially surrounding the first second sub-pixel 221.

In an implementation, as shown in FIG. 18, which is an enlarged schematic diagram of a first second sub-pixel, a third partition sub-portion and a support portion according to an embodiment of the present disclosure, the third partition sub-portion 321 includes the second notch 42 corresponding to the vertex angle A of the first second sub-pixel 221.

In an implementation, as shown in FIG. 1, FIG. 7, FIG. 8 and FIG. 10, along the third direction h13, at least some of the support portions 5 are each located between the first second sub-pixel 221 and the first first sub-pixel 211.

In an implementation, as shown in FIG. 7, along the fourth direction h14, some of the support portions 5 are each located between the first second sub-pixel 221 and the first first sub-pixel 211.

In the embodiment of the present disclosure, the second notch 42 is disposed to correspond to the vertex angle A of the first second sub-pixel 221, so that the second electrode 202 has a greater thickness at this vertex angle A, and thus the second electrode 202 of the first second sub-pixel 221 has a reliable connection at the vertex angle A.

For example, as shown in FIG. 1, FIG. 7, FIG. 8 and FIG. 10, the second notch 42 corresponding to one vertex angle A of the first second sub-pixel 221 is located at a side of the first second sub-pixel 221 close to the support portion 5. Because the first second sub-pixel 221 is disposed adjacent to the support portion 5, in the embodiment of the present disclosure, the second notch 42 corresponding to the vertex angle A of the first second sub-pixel 221 is provided at the side of the first second sub-pixel 221 close to the support portion 5. Thus, no protrusion portion or recessed portion is provided at a periphery of the vertex angle A of the first second sub-pixel 221 close to the support portion 5, thereby preventing the protrusion portion or the recessed portion from occupying the space for the support portion 5, and reducing the difficulty in disposing the support portion 5. In addition, based on this arrangement, the supporting effect of the support portion 5 is ensured without excessively reducing the area of the support portion 5.

For example, further referring to FIG. 7 and FIG. 10, the first second sub-pixel 221 includes at least two vertex angles A, the third partition sub-portion 321 includes at least two second notches 42. Two second notches 42 each correspond to a different vertex angle A. One of the two second notches 42 is located at the side of the first second sub-pixel 221 close to the support portion 5, and the other of the two second notches 42 is located at a side of the first second sub-pixel 221 away from the support portion 5. The second notch 42 disposed close to the support portion 5 prevents the provision of the protrusion portion or the recessed portion at the periphery of the vertex angle A of the first second sub-pixel 221 close to the support portion 5, thereby preventing the protrusion portion or the recessed portion from occupying the space for the support portion 5, and reducing the difficulty in disposing the support portion 5. Moreover, the disposition of the second notch 42 away from the support portion 5 increases the number of the second notches 42, thereby providing more reliable connection positions for the second electrode and increasing the number of conduction paths for the signal transmitted by the second electrode. For example, at least along the arrangement direction of the two second notches 42, a signal is smoothly transmitted by the second electrode.

In an embodiment of the present disclosure, further referring to FIG. 7, a length of the second notch 42 away from the support portion 5 is S211, and a length of the second notch 42 close to the support portion 5 is S212, where S211≤S212. Based on this arrangement, by making the length of the second notch 42 close to the support portion 5 larger, the distance between the support portion 5 and the non-notch portion of the third partition sub-portion 321 is increased, which further reduces the difficulty in disposing the support portion 5.

For example, the length of the support portion 5 in the fourth direction h14 is S5, where S211≤S5≤S212. In this way, the distance between the support portion 5 and the first second sub-pixel 221 is reduced, while the mutual influence between the third partition sub-portion 321 and the support portion 5 is avoided. For example, the area of the first second sub-pixel 221 can be set as large as possible to prolong the service life of the first second sub-pixel 221 and improve the display effect of the display panel 100.

For example, as shown in FIG. 1, FIG. 8 and FIG. 18, the first second sub-pixel 221 further includes multiple first second edges E21, and two adjacent first second edges E21 form the vertex angle A of the first second sub-pixel 221. FIG. 1, FIG. 8 and FIG. 18 schematically show that the first second sub-pixel 221 has four first second edges E21: three straight segments and one arc.

As shown in FIG. 1, FIG. 8 and FIG. 18, the third partition sub-portion 321 further includes a second notch 42 corresponding to one of the first second edges E21. A length of the second notch 42 corresponding to the first second edge E21 is S213, and the length of the second notch 42 corresponding to the vertex angle A of the first second sub-pixel 221 and close to the support portion 5 is S212, where S213≤S212. Based on this arrangement, by making the length of the second notch 42 close to the support portion 5 larger, the distance between the support portion 5 and the non-notch portion of the third partition sub-portion 321 is increased, thereby further reducing the difficulty in disposing the support portion 5. In addition, by making the length of the second notch 42 corresponding to the first second edge E21 as small as possible, the area of the lateral leakage current region at the periphery of the first second sub-pixel 221 is reduced, thereby improving the reliability of the display panel.

For example, as shown in FIG. 18, the length of the support portion 5 in the fourth direction h14 is S5, where S213≤S5≤S212. In this way, the distance between the support portion 5 and the first second sub-pixel 221 is reduced, while the mutual influence between the third partition sub-portion 321 and the support portion 5 is avoided. For example, the area of the first second sub-pixel 221 can be set as large as possible to prolong the service life of the first second sub-pixel 221 and improve the display effect of the display panel 100.

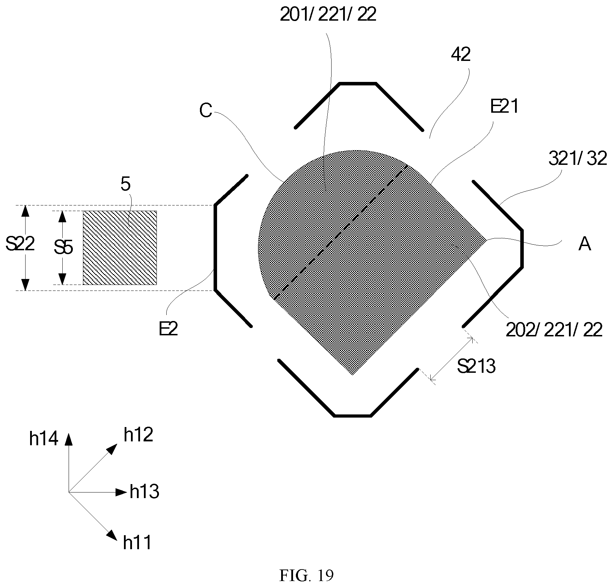

For example, as shown in FIG. 16 and FIG. 19, the first second sub-pixel 221 includes the protrusion portion 201 and the body portion 202, where FIG. 19 is an enlarged schematic diagram of a first second sub-pixel, a third partition sub-portion and a support portion in FIG. 16. At least a portion of the arc C is located at the side of the first second sub-pixel 221 close to the support portion 5. FIG. 19 schematically shows that a portion of the arc C is disposed at the side of the first second sub-pixel 221 close to the support portion 5. The expression "a portion of the arc C is disposed at the side of the first second sub-pixel 221 close to the support portion 5" means that a line connecting the centroid of the virtual circumscribed quadrilateral of the first second sub-pixel 221 and the centroid of the support portion 5 passes through the arc C. In an embodiment of the present disclosure, the second partition portion 32 includes a second edge E2 located between the portion of the arc C and the support portion 5.

Based on this arrangement, on one hand, the formation of the second notch at the second edge E2 is avoided, so that a part of the second partition portion 32 at the second edge E2 is used to prevent the leakage current from peripheral sub-pixels from affecting the first second sub-pixel 221, thereby avoiding the formation of a leakage current channel at this position and improving the consistency of leakage current paths between this region and another region where no support portion 5 is provided. For example, the consistency of leakage current paths at the periphery of the first second sub-pixel 221 and the periphery of the second second sub-pixel 222 is improved, thereby improving the display uniformity of the display panel.

On the other hand, by providing the second edge E2, instead of a corner structure protruding toward the support portion 5, at this position of the second partition portion 32, a sufficient distance is maintained between the second partition portion 32 and the support portion 5, which not only reduces the difficulty in disposing the second partition portion 32 and the support portion 5, but also avoids reducing the area of the support portion 5, thereby ensuring the support effect of the support portion 5.

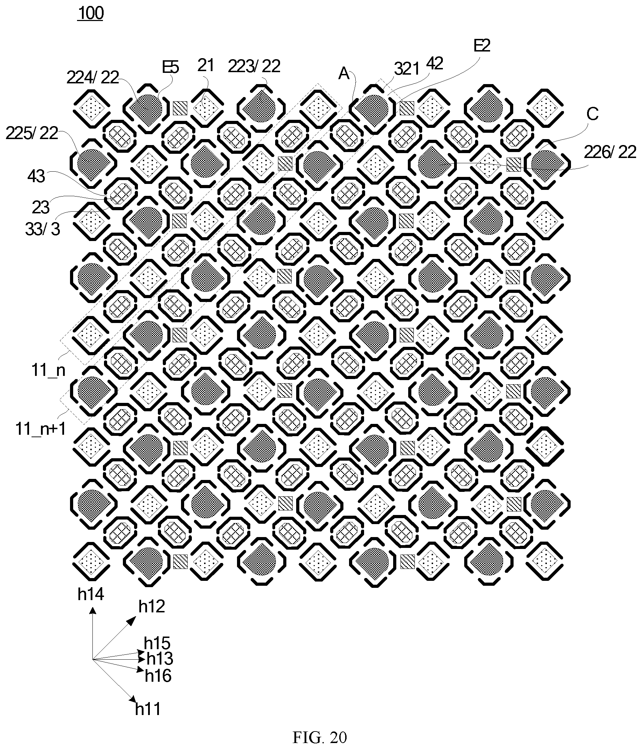

In another optional implementation, as shown in FIG. 20, which is a schematic diagram of a display panel according to yet another embodiment of the present disclosure, when the second partition portion 32 includes the second edge E2, the first sub-pixel 21 may be configured as a quadrilateral. The difference between FIG. 20 and FIG. 16 lies only in the shape of the first sub-pixel 21, and all other features are identical.

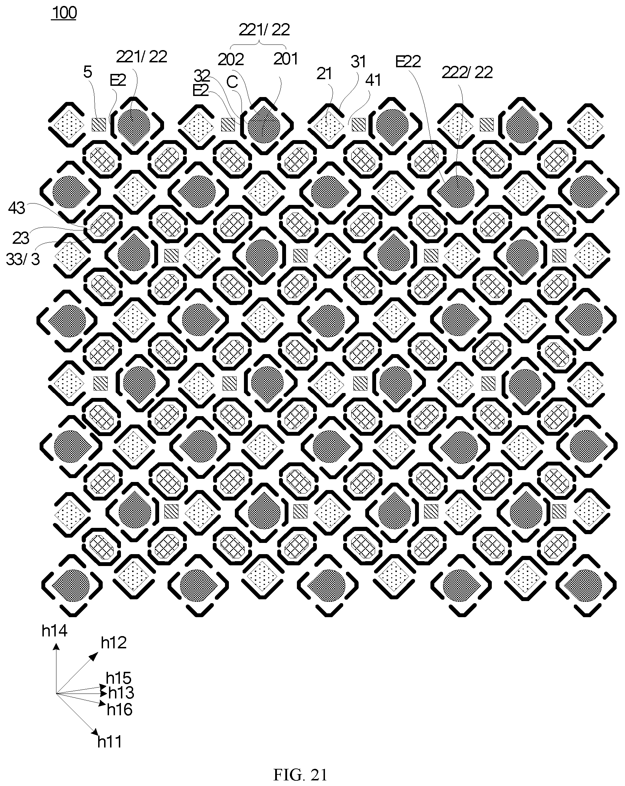

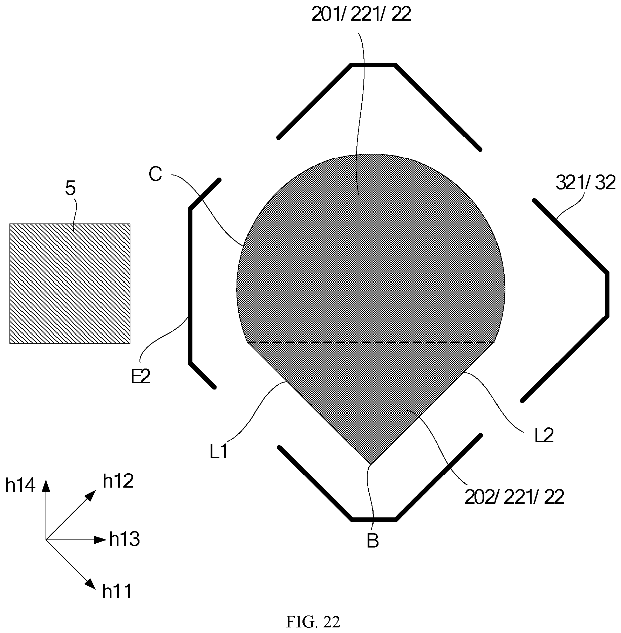

In an embodiment of the present disclosure, when disposing the first second sub-pixel 221, for example, as shown in FIG. 21 and FIG. 22, the body portion 202 may be configured to include a first straight segment L1 and a second straight segment L2, where FIG. 21 is a schematic diagram of a display panel according to yet another embodiment of the present disclosure, and FIG. 22 is an enlarged schematic diagram of a first second sub-pixel, a third partition sub-portion and a support portion in FIG. 21. The first straight segment L1 and the second straight segment L2 intersect with each other. One end of the arc C is connected to the first straight segment L1, and the other end of the arc C is connected to the second straight segment L2. The first straight segment L1 and the second straight segment L2 intersect at a first vertex B. That is, the first second sub-pixel 221 is designed to be approximately teardrop-shaped.

In an implementation, as shown in FIG. 21, the third partition sub-portion 321 includes a second edge E2 located between at least a part of the arc C and the support portion 5.

It should be noted that FIG. 21 schematically shows that the second sub-pixel 22 is designed to be approximately teardrop-shaped and the first sub-pixel 21 is designed to be quadrilateral. When the first sub-pixel 21 is designed to be a structure including the protrusion portion and the body portion, in an embodiment of the present disclosure, the first sub-pixel 21 may be designed to be approximately teardrop-shaped, which will not be illustrated in the drawings.

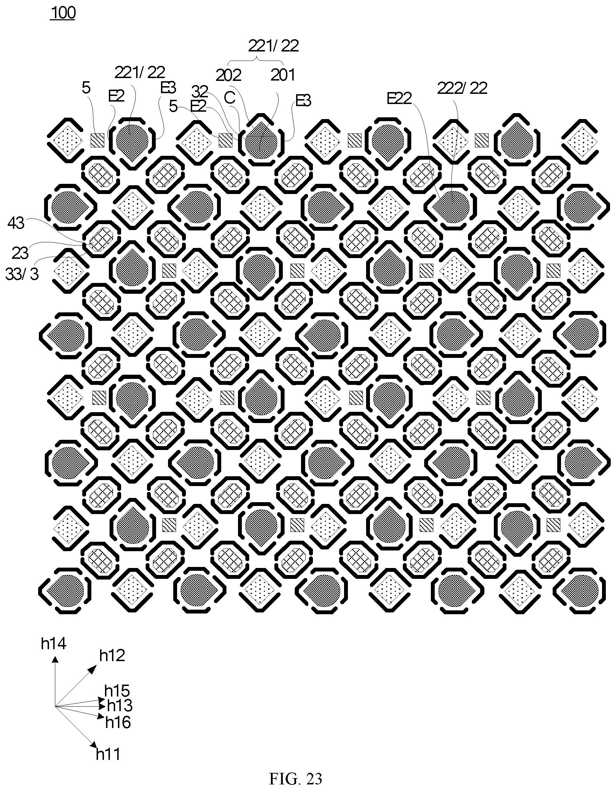

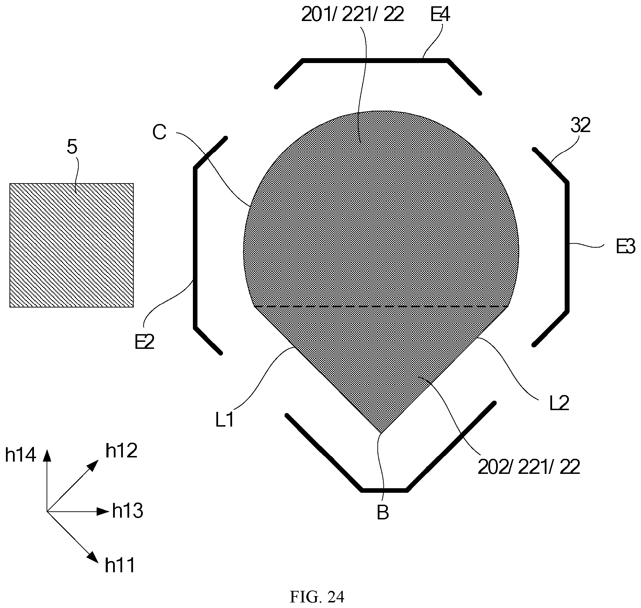

As shown in FIG. 23 and FIG. 24, the shape of the first second sub-pixel 221 is the same as that in FIG. 21, where FIG. 23 is a schematic diagram of a display panel according to yet another embodiment of the present disclosure, and FIG. 24 is an enlarged schematic diagram of a first second sub-pixel, a third partition sub-portion and a support portion in FIG. 23. The difference from FIG. 21 is that in FIG. 23 and FIG. 24, the second partition portion 32 includes, in addition to the second edge E2, a third edge E3 located at a side of the first second sub-pixel 221 away from the second edge E2.

Based on this arrangement, on one hand, the formation of the second notch at the third edge E3 is avoided, so that a part of the second partition portion 32 at the third edge E3 is used to prevent the leakage current from peripheral sub-pixels from affecting the first second sub-pixel 221, thereby avoiding the formation of a leakage current channel at this position and improving the consistency of leakage current paths between this region and another region where no support portion 5 is provided. For example, the consistency of leakage current paths at the periphery of the first second sub-pixel 221 and the periphery of the second second sub-pixel 222 is improved, thereby improving the display uniformity of the display panel.

On the other hand, by providing the third edge E3-instead of a corner structure protruding away from the first second sub-pixel 221 in the third direction h13-at this position of the second partition portion 32, the area of the region defined by the contour of the second partition portion 32 is reduced, thereby saving space for the sub-pixel.

For example, as shown in FIG. 23 and FIG. 24, in an embodiment of the present disclosure, the second partition portion 32 further includes a fourth edge E4 that is located at a side of the second sub-pixel 22 away from the first vertex B. Based on this arrangement, the second partition portion 32 includes no corner structure at the arc C of the second sub-pixel 22 that protrudes away from the first second sub-pixel 221 in the fourth direction h14, thereby further reducing the area of the region defined by the contour of the second partition portion 32.

For example, further referring to FIG. 19, the first second sub-pixel 221 further includes multiple first second edges E21. Two adjacent first second edges E21 form the vertex angle A of the first second sub-pixel 221. The third partition sub-portion 321 further includes the second notch 42 corresponding to one of the first second edges E21. The first second edge E21 may be a straight segment or an arc. FIG. 19 schematically shows that the first second sub-pixel 221 includes four first second edges E21: three straight segments and one arc, and the third partition sub-portion 321 includes three second notches 42 corresponding to the three straight segments respectively, and one second notch 42 corresponding to the one arc.

As shown in FIG. 19, a length of the second notch 42 corresponding to the first second edge E21 is S213, and a length of the second edge E2 is S22, where S213≤S22. Based on this arrangement, by making the length of the second edge E2 close to the support portion 5 larger, the distance between the support portion 5 and the third partition sub-portion 321 is increased, thereby further reducing the disposing difficulty of the support portion 5. In addition, by making the length of the second notch 42 corresponding to the first second edge E21 as small as possible, the area of the lateral leakage current region is reduced, thereby further improving the reliability of the display panel.

For example, as shown in FIG. 19, the length of the support portion 5 in the fourth direction h14 is S5, where S213≤S5≤S22. In this way, the distance between the support portion 5 and the first second sub-pixel 221 is reduced, while the mutual influence between the third partition sub-portion 321 and the support portion 5 is avoided. For example, the area of the first second sub-pixel 221 can be set as large as possible to prolong the service life of the first second sub-pixel 221 and improve the display effect of the display panel 100.

For example, further referring to FIG. 16, the second sub-pixel 22 includes the protrusion portion 201 and the body portion 202. The protrusion portion 201 includes a fifth edge E5 away from the body portion 202. The second sub-pixel 22 has a virtual circumscribed quadrilateral. The second sub-pixel 22 includes a fifth-type sub-pixel 223, a sixth-type sub-pixel 224, a seventh-type sub-pixel 225 and an eighth-type sub-pixel 226. A direction from a centroid of an orthographic projection of the virtual circumscribed quadrilateral of the fifth-type sub-pixel 223 onto a plane of the substrate to a center of the fifth edge E5 is parallel to the first direction h11. A direction from a centroid of an orthographic projection of the virtual circumscribed quadrilateral of the sixth-type sub-pixel 224 onto the plane of the substrate to a center of the fifth edge E5 is parallel to the second direction h12. A direction from a centroid of an orthographic projection of the virtual circumscribed quadrilateral of the seventh-type sub-pixel 225 onto the plane of the substrate to a center of the fifth edge E5 is parallel to an opposite direction of the first direction h11. A direction from a centroid of an orthographic projection of the virtual circumscribed quadrilateral of the eighth-type sub-pixel 226 onto the plane of the substrate 1 to a center of the fifth edge E5 is parallel to an opposite direction of the second direction h12. The center of the fifth edge E5 refers to a midpoint of a connecting line between two endpoints of the fifth edge E5.

When arranging the fifth-type sub-pixel 223, sixth-type sub-pixel 224, seventh-type sub-pixel 225 and eighth-type sub-pixel 226, for example, as shown in FIG. 16, in any row of sub-pixels, for example, in a (m+1)-th row of sub-pixels 11_m+1, in an embodiment of the present disclosure, the fifth-type sub-pixel 223, the seventh-type sub-pixel 225, the sixth-type sub-pixel 224 and the eighth-type sub-pixel 226 can be arranged alternately in sequence along the first direction h11; and in any column of sub-pixels, for example, in a (n+1)-th column of sub-pixels 11_n+1, in an embodiment of the present disclosure, the fifth-type sub-pixel 223, the eighth-type sub-pixel 226, the sixth-type sub-pixel 224 and the seventh-type sub-pixel 225 can be arranged alternately in sequence along the second direction h12. Based on this arrangement, the second sub-pixels 22 having differently oriented protrusion portions 201 can be made uniformly distributed in the display panel, which is beneficial to improving the display uniformity.

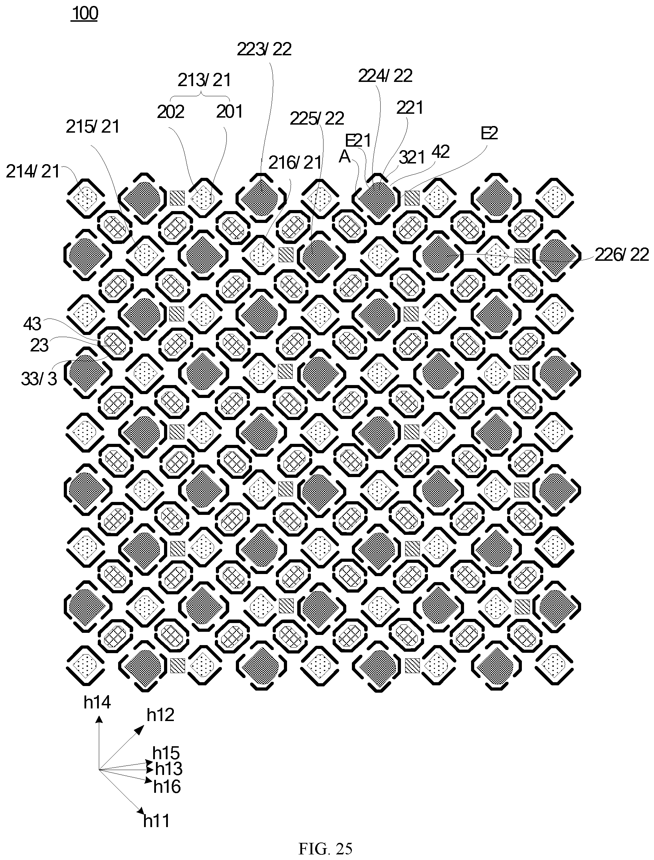

When providing the second sub-pixel 22, for example, as shown in FIG. 25 and FIG. 12C, the second sub-pixel 22 includes the protrusion portion 201 and the body portion 202, where FIG. 25 is a schematic diagram of a display panel according to yet another embodiment of the present disclosure, and FIG. 12C may be considered as an enlarged schematic diagram of the second sub-pixel in FIG. 25. The arc C includes a first arc C1 and a second arc C2. An edge of the protrusion portion 201 away from the body portion 202 further includes a straight segment L connecting the first arc C1 and the second arc C2. A length of the first arc C1 is greater than a length of the second arc C2. Two endpoints of the first arc C1 are P1 and P2, two endpoints of the second arc C2 are P3 and P4, and two endpoints of the straight segment L are P2 and P3. For example, as shown in FIG. 12C, a distance between P1 and P2 in the first direction h11 is d1, and a distance between P3 and P4 in the first direction h11 is d2, where d1≠d2. Based on this arrangement, the flexibility in designing the shape of the second sub-pixel 22 is improved.

As shown in FIG. 1, FIG. 7, FIG. 8, FIG. 9, FIG. 10, FIG. 11, FIG. 16, FIG. 21 and FIG. 23, the second sub-pixel 22 further includes a second second sub-pixel 222. No support portion 5 is provided between the second second sub-pixel 222 and its adjacent first sub-pixel 21. In an embodiment of the present disclosure, no support portion 5 is provided between the second second sub-pixel 222 and the first sub-pixel 21 which are adjacent in the third direction h13. Moreover, no support portion 5 is provided between the second second sub-pixel 222 and the first sub-pixel 21 which are adjacent in the fourth direction h14.

For example, as shown in FIG. 7 and FIG. 10, the second second sub-pixel 222 includes a vertex angle A, and the second partition portion 32 includes a fourth partition sub-portion 322. The fourth partition sub-portion 322 at least partially surrounds the second second sub-pixel 222, and includes the second notch 42 corresponding to the vertex angle A of the second second sub-pixel 222. The provision of the second notch 42 ensures good connection of the second electrode located at the periphery of the vertex angle A of the second second sub-pixel 222.

For example, as shown in FIG. 1, FIG. 8, FIG. 9, FIG. 11, FIG. 16, FIG. 21 and FIG. 23, the second second sub-pixel 222 further includes multiple second second edges E22. Two adjacent second second edges E22 form the vertex angle A of the second second sub-pixel 222. The fourth partition sub-portion 322 further includes the second notch 42 corresponding to one of the second second edges E22. A length of the second notch 42 corresponding to the second second edge E22 is S222. As shown in FIG. 18, the length of the second notch 42 corresponding to the vertex angle A of the first second sub-pixel 221 and close to the support portion 5 is S212. In an embodiment of the present disclosure, S222≤S212. In the embodiment of the present disclosure, by making the length of the second notch 42 close to the support portion 5 larger, the distance between the support portion 5 and the third partition sub-portion 321 is increased, thereby further reducing the difficulty in disposing the support portion 5. In addition, by making the length of the second notch 42 corresponding to the second second edge E22 as small as possible, the area of the lateral leakage current region at the periphery of the second second sub-pixel 222 is reduced, thereby further improving the display effect of the display panel.

Optionally, in an embodiment of the present disclosure, S222=S213.

For example, in an embodiment of the present disclosure, S212=2×S213=2×S222. Based on this arrangement, as shown in FIG. 1 and FIG. 8, when the third partition sub-portion 321 is configured to include two second notches 42 respectively corresponding to different first second edges E21 and one second notch 42 corresponding to the vertex angle A of the first second sub-pixel 221, and the fourth partition sub-portion 322 is configured to include four second notches 42 respectively corresponding to different second second edges E22, a ratio of an area of the second notches 42 at the periphery of the first second sub-pixel 221 to an area of the second partition portion 32 is identical with a ratio of an area of the second notches 42 at the periphery of the second second sub-pixel 222 to an area of the second partition portion 32, so that unintended light emission degrees of the first second sub-pixel 221 and the second second sub-pixel 222 become consistent, thereby improving the display consistency of different regions in the display panel.

For example, further referring to FIG. 9 and FIG. 10, the second sub-pixel 22 includes the first second sub-pixel 221 and the second second sub-pixel 222, and the second partition portion 32 includes a first second partition portion 323 and a second second partition portion 324. The first second partition portion 323 at least partially surrounds the first second sub-pixel 221, and the second second partition portion 324 at least partially surrounds the second second sub-pixel 222. For example, the first second partition portion 323 includes the third partition sub-portion 321, and the second second partition portion 324 includes the fourth partition sub-portion 322.

In an embodiment of the present disclosure, a shape of the first second partition portion 323 is the same as a shape of the second second partition portion 324; a length of the first second partition portion 323 is the same as a length of the second second partition portion 324; and a width of the first second partition portion 323 is the same as a width of the second second partition portion 324. For each of the first second partition portion 323 and the second second partition portion 324, a lengthwise direction refers to a direction along which the partition portion extends, and a widthwise direction is perpendicular to the direction along which the partition portion extends. A length of the second notch 42 in the first second partition portion 323 is the same as a length of the second notch 42 in the second second partition portion 324.

As shown in FIG. 9 and FIG. 10, the first second sub-pixel 221 can coincide with the second second sub-pixel 222 by translation. The first second partition portion 323 can coincide with the second second partition portion 324 by translation. The second notch 42 in the first second partition portion 323 can coincide with the second notch 42 in the second second partition portion 324 by translation.

Based on this arrangement, the distributions of the second partition portions 32 and the second notches 42 at the peripheries of the first second sub-pixel 221 and the second second sub-pixel 222, which have different positional relationships with the support portion 5, can be made the same, so that the lateral leakage current magnitudes at the peripheries become consistent, and the morphologies of the second electrodes of the first second sub-pixel 221 and the second second sub-pixel 222 become consistent, thereby improving the display uniformity of the display panel.

For example, as shown in FIG. 10, in an embodiment of the present disclosure, the second notch 42 in the first second partition portion 323 can be disposed corresponding to a vertex angle A of the first second sub-pixel 221, and the second notch 42 in the second second partition portion 324 can be disposed corresponding to a vertex angle A of the second second sub-pixel 222.

Or, as shown in FIG. 9, in an embodiment of the present disclosure, the second notch 42 in the first second partition portion 323 can be disposed corresponding to an edge of the first second sub-pixel 221, and the second notch 42 in the second second partition portion 324 can be disposed corresponding to an edge of the second second sub-pixel 222.

Optionally, based on the arrangement in FIG. 9, widths of the first second partition portion 323 and the second second partition portion 324 can be appropriately compressed to avoid the mutual influence between the first second partition portion 323 and the support portion 5. Optionally, widths W of the first second partition portion 323 and the second second partition portion 324 may satisfy 1.5µm≤W≤3.5µm.

For example, as shown in FIG. 7, no partition portion is provided at the periphery of the third sub-pixel 23. Based on this arrangement, the signal transmitted by the second electrode (not shown in FIG. 7) of the sub-pixel can be input from the bezel regions at both sides of the display panel in the third direction h13 and transmitted along the third direction h13 to form a current transmission channel, which is beneficial to reducing the voltage drop of the signal transmitted by the second electrode in the transmission process and improving the display effect. FIG. 7 shows one of the transmission paths of the above-mentioned signal with a straight line with an arrow.

Moreover, as shown in FIG. 7, in the display panel, for a unit area, the number of the third sub-pixels 23 is greater than the number of the first sub-pixels 21 and the number of the second sub-pixels 22. In the embodiment of the present disclosure, by not providing a partition portion at the periphery of the third sub-pixel 23, and by providing the first partition portion 31 and the second partition portion 32 at the peripheries of the first sub-pixel 21 and the second sub-pixel 22, respectively, in the manner shown in FIG. 7, there is a better improvement effect for the problem of unintended light emission of the first sub-pixel 21. For example, when the first sub-pixel 21 is provided as a red sub-pixel, the second sub-pixel 22 is provided as a blue sub-pixel, and the third sub-pixel 23 is provided as a green sub-pixel, and when the display panel displays a blue image, in the related art, under different brightness, the problem of unintended light emission of the red sub-pixel will cause the color coordinate of the blue image to change significantly, resulting in a red color cast issue in visual effect. In contrast, based on the arrangement provided in FIG. 7, the phenomenon of unintended light emission of the red sub-pixel under a blue image can be well suppressed. Moreover, the occupied area of the partition portions 3 can also be reduced, and the conduction paths of the signal transmitted by the second electrode can be increased, which is more beneficial to reducing the voltage drop of the signal in the transmission process, reducing the power consumption of the display panel, and improving the display uniformity of the display panel.

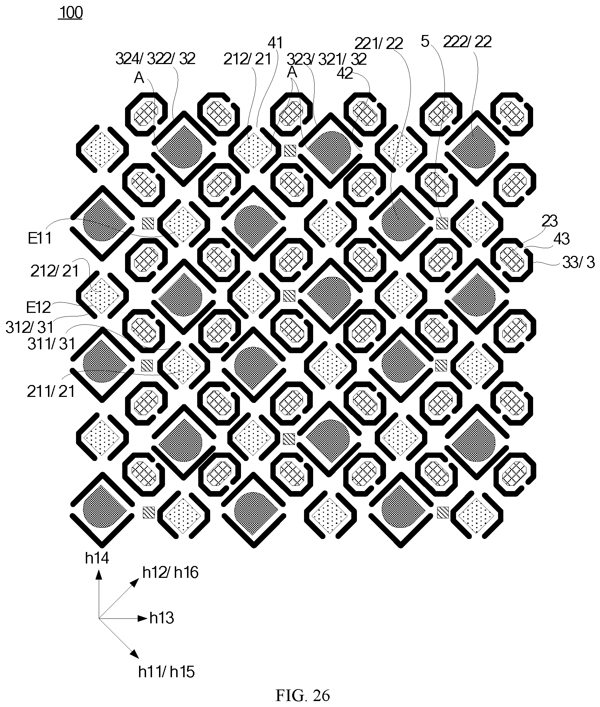

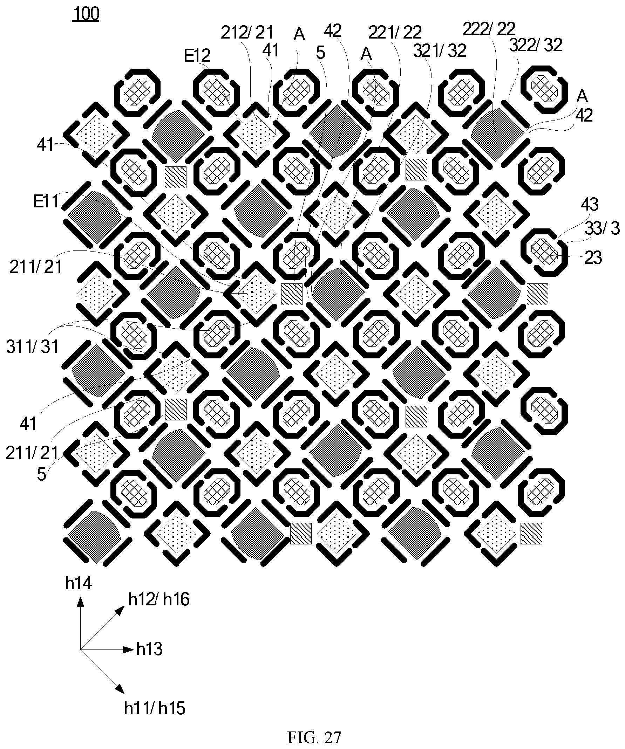

For example, as shown in FIG. 1, FIG. 8, FIG. 9, FIG. 10, FIG. 11, FIG. 16, FIG. 21, FIG. 23, FIG. 25, FIG. 26 and FIG. 27, where FIG. 26 and FIG. 27 are schematic diagrams of another two display panels according to embodiments of the present disclosure, the partition portion 3 further includes a third partition portion 33. The third partition portion 33 at least partially surrounds the third sub-pixel 23 and includes at least one third notch 43. The provision of the third partition portion 33 can extend or block the lateral leakage transmission path between the third sub-pixel 23 and the adjacent sub-pixel with a different color, such as the first sub-pixel 21 or the second sub-pixel 22, thereby improving the display effect of the display panel. The provision of the third notch 43 can improve the connection reliability of the second electrode at this position, thereby improving the display uniformity of the display panel.

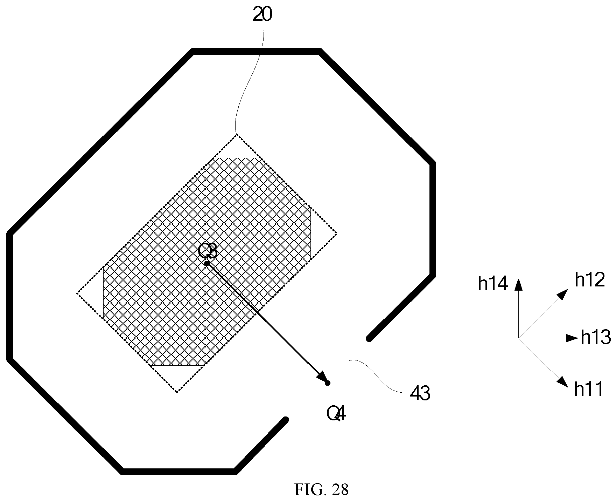

For example, as shown in conjunction with FIG. 10, FIG. 11, FIG. 26 and FIG. 28, where FIG. 28 is an enlarged schematic diagram of a third sub-pixel and a third partition portion according to an embodiment of the present disclosure, the third sub-pixel 23 has a virtual circumscribed quadrilateral 20, and a direction from a centroid Q3 of an orthographic projection of the virtual circumscribed quadrilateral 20 of the third sub-pixels 23 onto a plane of the substrate 1 to a center Q4 of the third notch 43 is parallel to the first direction h11 or the second direction h12. The center of the third notch 43 refers to a midpoint of a connecting line between two endpoints of the third partition portion 33 forming the third notch 43.

FIG. 10 is schematically shown with the third partition portion 33 including two third notches 43, the direction from the centroid of the orthographic projection of the virtual circumscribed quadrilateral of each of a part of the third sub-pixels 23 onto the plane of the substrate 1 to the center of one of the third notches 43 being parallel to the second direction h12, and the direction from the centroid of the orthographic projection of the virtual circumscribed quadrilateral of each of the other part of the third sub-pixels 23 onto the plane of the substrate 1 to the center of the third notch 43 being parallel to the first direction h11.

FIG. 11 is schematically shown with the third partition portion 33 including two third notches 43 arranged along the first direction h11, the direction from the center of the orthographic projection of the virtual circumscribed quadrilateral of the third sub-pixel 23 onto the plane of the substrate 1 to the center of one of the third notches 43 being parallel to the first direction h11, and the direction from the center of the orthographic projection of the virtual circumscribed quadrilateral 20 of the third sub-pixel 23 onto the plane of the substrate 1 to the center of the other third notch 43 being parallel to the opposite direction of the first direction h11.

FIG. 26 is schematically shown with the third partition portion 33 including one third notch 43, the direction from the centroid of the orthographic projection of the virtual circumscribed quadrilateral of each of a part of the third sub-pixels 23 onto the plane of the substrate 1 to the center of the third notch 43 being parallel to the second direction h12, and the direction from the centroid of the orthographic projection of the virtual circumscribed quadrilateral of the other part of the third sub-pixels 23 onto the plane of the substrate 1 to the center of the third notch 43 being parallel to the first direction h11. By comparing FIG. 26 and FIG. 10, it can be seen that the difference between the two is only in the number of the third notches 43, and other arrangements is the same. In FIG. 10, the third partition portion 43 includes two third notches, and in FIG. 26, the third partition portion 43 includes only one third notch 43.

FIG. 28 is schematically shown with the third partition portion 33 including one third notch 43, and the direction from the centroid Q3 of the orthographic projection of the virtual circumscribed quadrilateral 20 of the third sub-pixel 23 onto the plane of the substrate 1 to the center Q4 of the third notch 43 being parallel to the first direction h11.

Further referring to FIG. 11, in which the first partition portion 31 includes two first notches 41 disposed corresponding to the edges of the first sub-pixel 21, and the second partition portion 32 includes two second notches 42 disposed corresponding to the edges of the second sub-pixel 22, and in conjunction with the above-described arrangements of the third partition portion 33 and third notch 43, the areas of the partition portions and the notches can be better balanced, thereby better balancing the effects of suppressing the unintended light emission of the sub-pixels and reducing the impedance of the second electrode. In addition, as shown in FIG. 11, the two first notches 41 corresponding to the first sub-pixel 21 are arranged along the second direction h12, the two second notches 42 corresponding to the second sub-pixel 22 are arranged along the second direction h12, and the two third notches 43 corresponding to the third sub-pixel 23 are arranged along the first direction h11. Since the first direction h11 is non-parallel to each of the third direction h13 and the fourth direction h14, and the second direction h12 is non-parallel to each of the third direction h13 and the fourth direction h14, the impedance of the second electrode in both the third direction h13 and the fourth direction h14 can be reduced, which is beneficial to lowering the voltage drop of the signal transmitted by the second electrode in the third direction h13 and the fourth direction h14, reducing the power consumption of the display panel.

In an optional implementation, as shown in FIG. 26, in an embodiment of the present disclosure, only one third notch 43 can be provided in the third partition portion 33. For two adjacent third sub-pixels 23, as shown in FIG. 26, in the embodiment of the present disclosure, the direction from the centroid of the orthographic projection of the virtual circumscribed quadrilateral of one of the third sub-pixels 23 onto the plane of the substrate 1 to the center of the third notch 43 may be parallel to the first direction h11, and the direction from the centroid of the orthographic projection of the virtual circumscribed quadrilateral of the other third sub-pixel 23 onto the plane of the substrate 1 to the center of the third notch 43 may be parallel to the second direction h12, so as to improve the distribution uniformity of the third notches 43 with different orientations in the display panel, thereby be capable of improving the transmission consistency of the signal transmitted by the second electrode in the display panel.

In another optional implementation, as shown in FIG. 1, FIG. 8, FIG. 9, FIG. 10, FIG. 16, FIG. 23, FIG. 25 and FIG. 27, in an embodiment of the disclosure, at least two third notches 43 can also be provided in the third partition portion 33. For two third sub-pixels 23 adjacently disposed in the third direction h13, in the embodiment of the present disclosure, the third notch 43 at a periphery of one third sub-pixel of the third sub-pixels 23 and the third notch 43 at a periphery of the other third sub-pixel 23 can be arranged along the third direction h13. Two third notches 43 at the periphery of the one third sub-pixel of the third sub-pixels 23 are arranged along the fifth direction h15, and two third notches 43 at the periphery of the other third sub-pixel 23 are arranged along the sixth direction h16. Based on this arrangement, the distribution uniformity of the third notches 43 with different orientations in the display panel can be improved, thereby being capable of improving the transmission consistency of the signal transmitted by the second electrode in the display panel.

For example, as shown in FIG. 10 and FIG. 27, in the embodiments of the disclosure, the fifth direction h15 can be parallel to the first direction h11, and the sixth direction h16 can be parallel to the second direction h12.

Optionally, in an embodiment of the present disclosure, the number of the first notches 41 included in the first partition portion 31 may be the same as the number of the third notches 43 included in the third partition portion 33, so as to balance the unintended light emission degrees of the first sub-pixel 21 and the third sub-pixel 23 and improve the display effect of the display panel. FIG. 1, FIG. 9, FIG. 10, FIG. 11, FIG. 16, FIG. 20, FIG. 21, FIG. 23 and FIG. 25 are schematically shown with two first notches 41 being provided in the first partition portion 31 at the periphery of the first sub-pixel 21, and two third notches 43 being also provided in the third partition portion 33 at the periphery of the third sub-pixel 23.

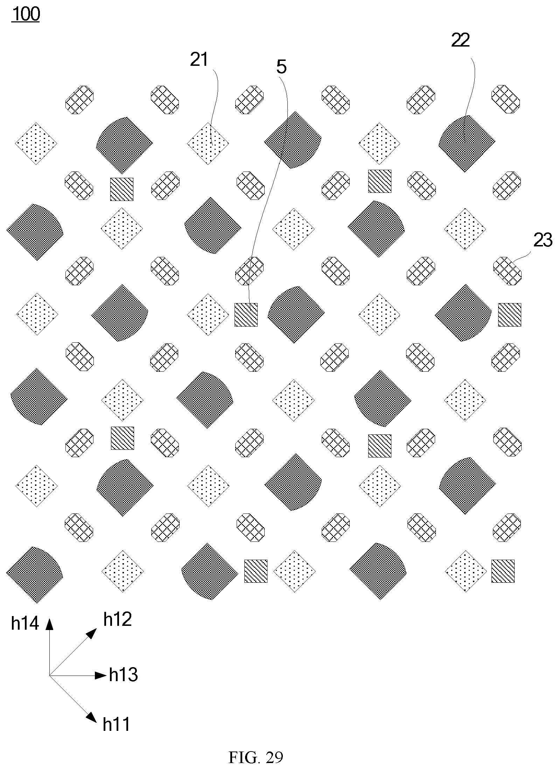

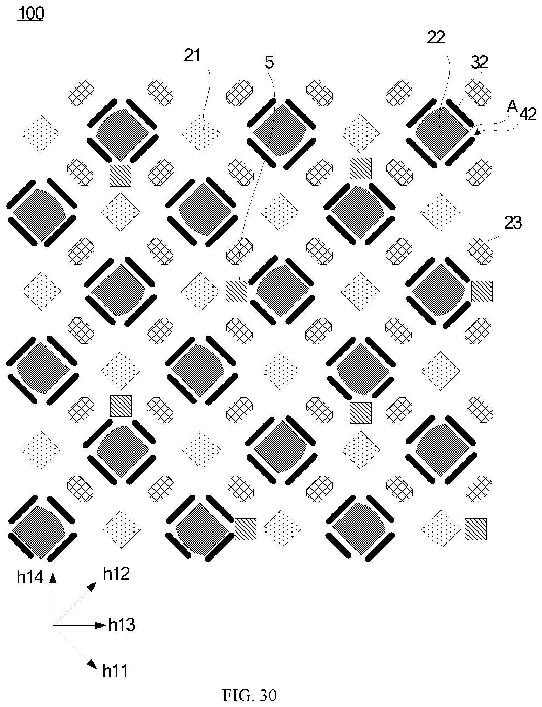

When the first sub-pixel 21 is a red sub-pixel, the second sub-pixel 22 is a blue sub-pixel, and the third sub-pixel 23 is a green sub-pixel, simulation tests have been performed on the solutions shown in FIG. 1, FIG. 7, FIG. 8, FIG. 9, FIG. 10, FIG. 26 and FIG. 27 and the two embodiments shown in FIG. 29 and FIG. 30, and the pixel arrangement rules of FIG. 29 and FIG. 30 are the same as those of FIG. 1, FIG. 7, FIG. 8, FIG. 9, FIG. 10, FIG. 26 and FIG. 27. Unlike in FIG. 1, FIG. 7, FIG. 8, FIG. 9, FIG. 10, FIG. 26 and FIG. 27, in FIG. 29, the first partition portion, the second partition portion and the third partition portion are not provided. In FIG. 30, the first partition portion and third partition portion are not provided, and only the second partition portion is provided.

The simulation results are shown in Table 1 below, where R@B_1 is used to represent the ratio of the light intensity of the red sub-pixels to the light intensity of the blue sub-pixels when the display panel displays a blue image. The larger the value of R@B_1 is, the more serious the unintended light emission of the red sub-pixels is. G@B_1 is used to represent the ratio of the light intensity of the green sub-pixels to the light intensity of the blue sub-pixels when the display panel displays a blue image. The larger the value of G@B_1 is, the more serious the unintended light emission of the green sub-pixels is.

**Table 1**

| | FIG. 29 | FIG. 30 | FIG. 1 | FIG. 7 | FIG. 8 | FIG. 9 | FIG. 10 | FIG. 26 | FIG. 27 |
|---|---|---|---|---|---|---|---|---|---|
| R@B_1 | 1.52% | 0.98% | 0.5% | 0.49% | 0.37% | 0.87% | 0.58% | 0.77% | 0.72% |
| G@B_1 | 5.47% | 2.00% | 1.11% | 2.61% | 1.08% | 0.54% | 0.63% | 0.33% | 1.19% |

Table 1 shows that, compared with the arrangements provided in FIG. 29 and FIG. 30, the solutions provided by the embodiments of the present disclosure shown in FIG. 1, FIG. 7, FIG. 8, FIG. 9, FIG. 10, FIG. 26 and FIG. 27 can all significantly achieve the effect of suppressing the unintended light emission of the red and green sub-pixels when the blue sub-pixels are emitting.

In addition, the phenomenon of unintended light emission of the red sub-pixels under a green image is simulated for the solutions shown in FIG. 1, FIG. 9, FIG. 10 and FIG. 26, with the results as shown in Table 2 below. R@G_1 is used to represent the ratio of the light intensity of the red sub-pixels to the light intensity of the green sub-pixels when the display panel displays a green image. The larger the value of R@G_1 is, the more serious the unintended light emission of the red sub-pixels are.

**Table 2**

| | FIG. 1 | FIG. 9 | FIG. 10 | FIG. 26 |
|---|---|---|---|---|
| R@G_1 | 0.65% | 0.73% | 0.66% | 0.36% |

Table 2 shows that the solutions shown in FIG. 1, FIG. 9, FIG. 10 and FIG. 26 provided by the embodiments of the present disclosure can all achieve the effect of suppressing the unintended light emission of the red sub-pixels when the green sub-pixels are emitting. In particular, based on the solution shown in FIG. 26, by configuring the third partition portion 33 to include only one third notch 43, reducing the number of the third notches 43 and increasing the length of the non-notch portions in the third partition portion 33, the unintended light emission of the red sub-pixels can be significantly suppressed.

In addition, the display uniformity is simulated for the solutions shown in FIG. 1, FIG. 9, FIG. 10 and FIG. 26, with the results as shown in Table 3 below. R@B_2 is used to represent the ratio of the minimum light intensity to the maximum light intensity of the red sub-pixels when the display panel displays a blue image. The larger the value of R@B_2 is, the better the display uniformity of the red sub-pixels is. G@B_2 is used to represent the ratio of the minimum light intensity to the maximum light intensity of the green sub-pixels when the display panel displays a blue image. The larger the value of G@B_2 is, the better the display uniformity of the green sub-pixels is. R@G_2 is used to represent the ratio of the minimum light intensity to the maximum light intensity of the red sub-pixels when the display panel displays a green image. The larger the value of R@G_2 is, the better the display uniformity of the red sub-pixels is.

**Table 3**

| | FIG. 1 | FIG. 9 | FIG. 10 | FIG. 26 |
|---|---|---|---|---|
| R@B_2 | 81.8% | 94.6% | 89.5% | 88.8% |
| G@B_2 | 48.9% | 94.6% | 98.5% | 97.5% |
| R@G_2 | 79.2% | 97.3% | 93.8% | 97.2% |

Table 3 shows that, compared with the solution shown in FIG. 1, for the blue image, the solutions shown in FIG. 9, FIG. 10 and FIG. 26 provided by the embodiments of the present disclosure can all achieve the effect of improving the brightness consistency of the green sub-pixels. Moreover, whether it is the solution shown in FIG. 1 or the solutions shown in FIG. 9, FIG. 10 and FIG. 26, the brightness consistency of the red sub-pixels is higher for the green image.

In addition, the resistance of the second electrode is simulated for the solutions shown in FIG. 1, FIG. 9, FIG. 10 and FIG. 26, with the results as shown in Table 4 below. RX is used to represent the resistance of the second electrode in the third direction, and RY is used to represent the resistance of the second electrode in the fourth direction.

**Table 4**

| | FIG. 1 | FIG. 9 | FIG. 10 | FIG. 26 |
|---|---|---|---|---|
| RX | 18.7 | 16.71 | 26.28 | 32.17 |
| RY | 42.64 | 24.99 | 36.98 | 41.63 |

Table 4 shows that the solutions shown in FIG. 1, FIG. 9, FIG. 10 and FIG. 26 provided by the embodiments of the present disclosure can all achieve the effect of reducing the resistance of the second electrode. In particular, in the third direction h13, based on the solutions provided in FIG. 1 and FIG. 9, the resistance of the second electrode can be reduced to less than 20 Ω/□, which can greatly reduce the loss of the signal transmitted by the second electrode in the transmission process, improve the display uniformity, and reduce the power consumption of the display panel.

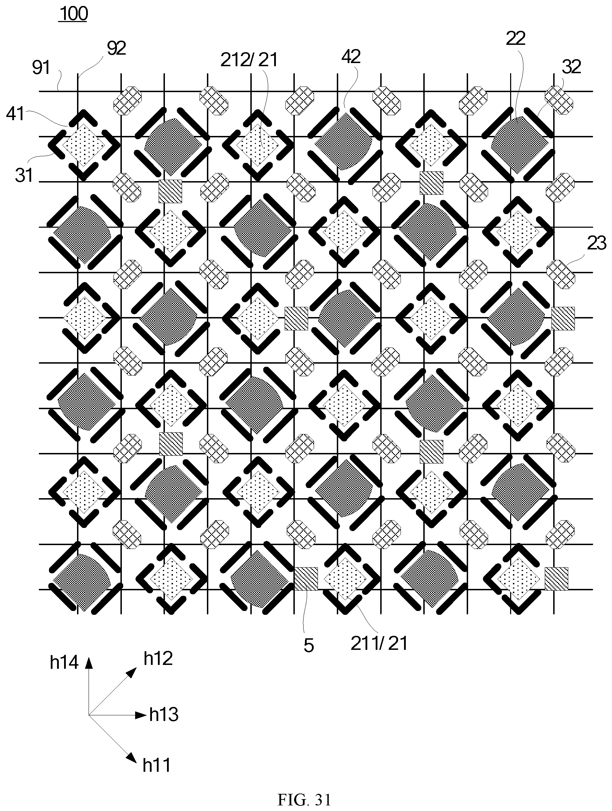

For example, as shown in FIG. 31, which is a schematic diagram of yet another display panel 100 according to an embodiment of the present disclosure, the display panel 100 further includes multiple scan lines 91 and multiple data lines 92. Each of the scan lines 91 extends along the above-mentioned third direction h13. The multiple scan lines 91 are arranged along the fourth direction h14. Each of the data lines 92 extends along the fourth direction h14. The multiple data lines 92 are arranged along the third direction h13.

As shown in FIG. 31, each of the scan lines 91 is electrically connected to multiple sub-pixels 2 arranged along the third direction h13, and each of the data lines 92 is electrically connected to multiple sub-pixels 2 arranged along the fourth direction h14.

For two adjacent scan lines 91, as shown in FIG. 31, one of the scan lines 91 is electrically connected to multiple first sub-pixels 21 and multiple third sub-pixels 23 that are alternately arranged in sequence along the third direction h13, and the other of the scan lines 91 is electrically connected to multiple second sub-pixels 22 that are arranged in sequence along the fifth direction h15. Moreover, the sub-pixels 2 connected to the two adjacent scan lines 91 are staggered in the sixth direction h16. For two adjacent data lines 92, one of the data lines 92 is electrically connected to multiple first sub-pixels 21 and multiple third sub-pixels 23 alternately arranged in sequence along the sixth direction h16, and the other of the data lines 92 is electrically connected to multiple second sub-pixels 22 arranged in sequence along the sixth direction h16. Moreover, the sub-pixels 2 connected to the two adjacent data lines 92 are staggered in the fifth direction h15. When the display panel 100 operates, the data lines 92 provide data voltages, and the multiple scan lines 91 sequentially provide control signals for controlling the sub-pixels 2 to start to be charged, so that the corresponding sub-pixels 2 are charged with the data voltages provided by the data lines 92 to emit light at desired brightness.

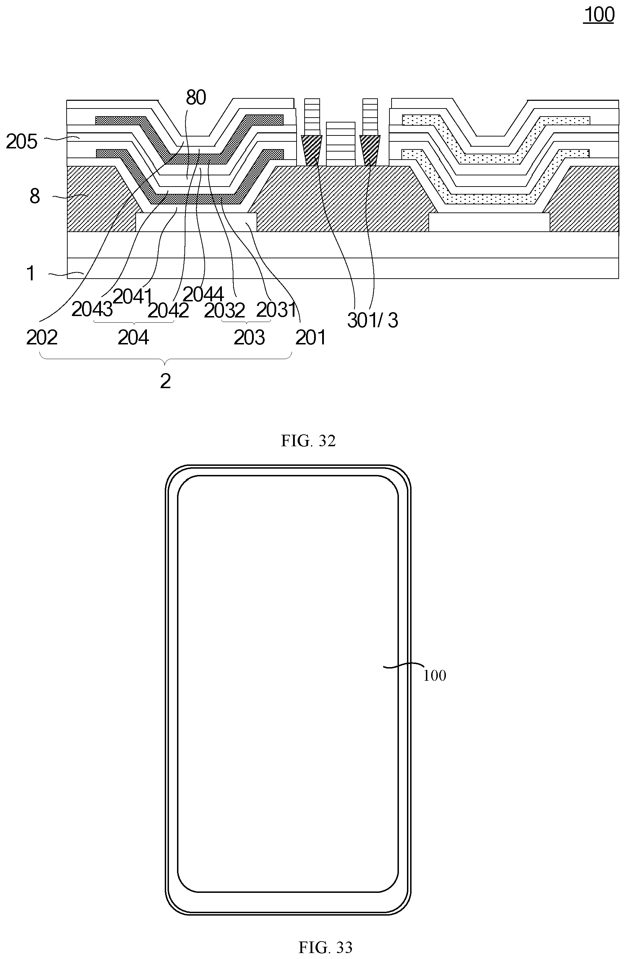

Optionally, as shown in FIG. 32, which is a schematic diagram of a cross-section of yet another display panel according to an embodiment of the present disclosure, the light-emitting layer 203 includes a first light-emitting layer 2031 and a second light-emitting layer 2032. The second light-emitting layer 2032 is located at a side of the first light-emitting layer 2031 away from the substrate 1. An orthographic projection of the second light-emitting layer 2032 onto the plane of the substrate 1 at least partially overlaps with an orthographic projection of the first light-emitting layer 2031 onto the plane of the substrate 1. At least a part of the first light-emitting layer 2031 and at least a part of the second light-emitting layer 2032 are located in the opening 80. For example, the first light-emitting layer 2031 and the second light-emitting layer 2032 may each be fabricated using a fine metal mask (FMM). The first light-emitting layer 2031 is deposited in the opening 80 of the pixel-defining layer 8 and may partially extend outside the opening 80. The first light-emitting layers 2031 of different sub-pixels 2 are independent of each other. The second light emitting layers 2032 of different sub-pixels 2 are independent of each other.

For example, the light-emitting colors of the first light-emitting layer 2031 and the second light-emitting layer 2032 may be the same or different.

As shown in FIG. 32, the sub-pixel 2 further includes a charge generation layer 205 located between the first light-emitting layer 2031 and the second light-emitting layer 2032.

For example, as shown in FIG. 32, the charge generation layer 205 may be disconnected at the position of the partition portion 3. Alternatively, the charge generation layer 205 may also be disposed at the partition portion 3 so as to protrude toward the side away from the substrate 1 to increase a transmission path of the lateral leakage current in the charge generation layer 205. Since the electrical conductivity of the charge generation layer 205 is relatively high, if no partition portion 3 is provided, the charges will migrate laterally between two adjacent sub-pixels 2 through the charge generation layer 205, which easily causes crosstalk between two adjacent sub-pixels 2, resulting in color cast of the display panel. In particular, the charge generation layer 205 easily causes crosstalk between sub-pixels of different colors under low brightness, resulting in low gray scale color cast. Based on the arrangement provided by the embodiment of the present disclosure, the problem of low gray scale color cast can be mitigated, and the display effect of the display panel can be improved.

In the display panel 100 provided by the embodiment of the present disclosure, by designing the sub-pixels 2 as a series structure including the first light-emitting layer 2031 and the second light-emitting layer 2032 disposed in a stacked manner, it is possible to improve the light-emitting brightness of the sub-pixels 2, reduce the power consumption of the display panel 100, and is beneficial to extend the service life of the display panel 100. Moreover, in the embodiment of the present disclosure, by providing the partition portion 3 in the display panel 100, it is possible to suppress or block the lateral leakage current between two adjacent sub-pixels 2, overcome the crosstalk between adjacent sub-pixels 2 caused by the high conductivity of the charge generation layer 205, and is beneficial to improve the display quality of the display panel 100.

Optionally, the charge generation layer 205 may include at least one of an N-type charge generation layer or a P-type charge generation layer.

Based on the same inventive concept, an embodiment of the present disclosure further provides a display apparatus, as shown in FIG. 33, which is a schematic diagram of a display apparatus according to an embodiment of the present disclosure, and the display apparatus includes the above-mentioned display panel 100. The specific structure of the display panel 100 has been described in detail in the foregoing embodiments, and details are not described herein again. Of course, the display apparatus shown in FIG. 33 is merely a schematic illustration, and the display apparatus may be any electronic device having a display function, such as a mobile phone, a vehicle-mounted display screen, a tablet computer, a notebook computer, an electronic paper book, or a television.

The above-described are only preferred embodiments of the present disclosure and are not intended to limit the present disclosure. All modifications, equivalent replacements, improvements, etc., made within the spirit and principle of the present disclosure shall be included within the scope of protection of the present disclosure.

Finally, it should be noted that, the above embodiments are merely used to illustrate the technical solutions of the present disclosure, but not to limit the same. Although the present disclosure has been described in detail with reference to the above embodiments, those of skill in the art should understand that the technical solutions recited in the above embodiments of the present disclosure may still be modified, or some or all of the technical features may be equivalently replaced. These modifications or substitutions do not make the essence of the corresponding technical solutions depart from the scope of the technical solutions in the embodiments of the present disclosure.

## Claims

1. A display panel, comprising:
a substrate;
a plurality of sub-pixels disposed on a same side of the substrate and arranged in an array along a first direction and a second direction, the plurality of sub-pixels comprising first sub-pixels, second sub-pixels, and third sub-pixels, wherein:
a first row of the plurality of sub-pixels comprises the first sub-pixels and the third sub-pixels alternately arranged along the first direction,
a second row, which is adjacent to the first row, of the plurality of sub-pixels comprises the third sub-pixels and the second sub-pixels alternately arranged along the first direction,
a first column of the plurality of sub-pixels comprises the first sub-pixels and the third sub-pixels alternately arranged along the second direction, and
a second column, which is adjacent to the first column, of the plurality of sub-pixels comprises the third sub-pixels and the second sub-pixels alternately arranged along the second direction, and
the second direction is non-parallel to the first direction; and
partition portions, comprising:
at least one first partition portion, each at least partially surrounding a respective one of the first sub-pixels and comprising at least one first notch; and
at least one second partition portion, each at least partially surrounding a
respective one of the second sub-pixels and comprising at least one second notch; and at least one support portion, wherein for each support portion:
along a third direction, the support portion is disposed between a respective first sub-pixel of the first sub-pixels and a second sub-pixel, adjacent to the respective first sub-pixel, of the second sub-pixels, and
along a fourth direction, the support portion is disposed between two respective adjacent third sub-pixels of the third sub-pixels, and
the third direction is non-parallel to each of the first direction and the second direction, the fourth direction is non-parallel to each of the first direction and the second direction, and the third direction is non-parallel to the fourth direction,
wherein for each pair of a first sub-pixel of the first sub-pixels and a second sub-pixel, adjacent to the first sub-pixel, of the second sub-pixels:
at least one of a non-notch portion of the first partition portion, a non-notch portion of the second partition portion, or the support portion is disposed between the first sub-pixel and the second sub-pixel,
at least one of the first sub-pixel or the second sub-pixel comprises a first protrusion portion and a body portion, and
an edge of the first protrusion portion away from the body portion comprises an arc protruding away from the body portion.

2. The display panel according to claim 1, wherein:
the first sub-pixels comprise a first first sub-pixel, and along at least one of the third direction or the fourth direction, a support portion of the at least one support portion is disposed between the first first sub-pixel and a second sub-pixel, adjacent to the first first sub-pixel, of the second sub-pixels, and
the first partition portion of the first first sub-pixel comprises a first partition sub-portion partially surrounding the first first sub-pixel, wherein the first partition sub-portion comprises a first notch, which is located at a corner of the first first sub-pixel, of the at least one first notch.

3. The display panel according to claim 2, wherein:
a quantity of the first notches in the first partition sub-portion is at least two, wherein each of the at least two first notches is located at a respective corner of the first first sub-pixel, and
one of the at least two first notches is located at a side of the first first sub-pixel close to the support portion, and another of the at least two first notches is located at a side of the first first sub-pixel away from the support portion.

4. The display panel according to claim 3, wherein:
a length of the first notch that is away from the support portion is S111,
a length of the first notch that is close to the support portion is S112, and
S111≤S112.

5. The display panel according to claim 2, wherein:
the first first sub-pixel further has a plurality of first first edges, wherein two adjacent first first edges form the corner, and the first partition sub-portion further comprises another first notch, which exposes a respective one of the plurality of first first edges, of the at least one first notch,
a length of the first notch exposing the respective first first edge is S113,
a length of the first notch located at the corner of the first first sub-pixel and close to the support portion is S112, and
S113≤S112.

6. The display panel according to claim 2, wherein:
the first sub-pixels comprise a second first sub-pixel, and none of the at least one support portion is disposed between the second first sub-pixel and a second sub-pixel, adjacent to the second first sub-pixel, of the second sub-pixels.

7. The display panel according to claim 6, wherein:
the first partition portion of the second first sub-pixel comprises a second partition sub-portion partially surrounding the second first sub-pixel, wherein the second partition sub-portion comprises a first notch, which is located at a corner of the second first sub-pixel, of the at least one first notch.

8. The display panel according to claim 7, wherein:
a quantity of the first notches in the second partition sub-portion is at least two, wherein each of the at least two first notches is located at a respective corner of the second first sub-pixel, and
along the third direction or the fourth direction, two of the at least two first notches are located at opposite sides of the second first sub-pixel.

9. The display panel according to claim 8, wherein:
a length of the first notch located at the respective corner of the second first sub-pixel is S121,
a length of the first notch located at the corner of the first first sub-pixel and close to the support portion is S112, and
S121≤S112.

10. The display panel according to claim 6, wherein:
the second first sub-pixel has a plurality of second first edges, wherein two adjacent second first edges form the corner, and the second partition sub-portion further comprises another first notch, which exposes a respective one of the plurality of second first edges, of the at least one first notch,
a length of the first notch exposing the respective second first edge is S122,
a length of the first notch located at the corner of the first first sub-pixel and close to the support portion is S112, and
S122≤S112.

11. The display panel according to claim 1, wherein:
the first sub-pixels comprise a first first sub-pixel and a second first sub-pixel, and along the third direction, a support portion of the at least one support portion is disposed between the first first sub-pixel and a second sub-pixel, adjacent to the first first sub-pixel, of the second sub-pixels, and none of the at least one support portion is disposed between the second first sub-pixel and a second sub-pixel, adjacent to the second first sub-pixel, of the second sub-pixels,
the first partition portion comprises a first first partition portion and a second first partition portion, the first first partition portion at least partially surrounds the first first sub-pixel, and the second first partition portion at least partially surrounds the second first sub-pixel,
a shape of the first first partition portion is the same as a shape of the second first partition portion,
a length of the first first partition portion is the same as a length of the second first partition portion, and a width of the first first partition portion is the same as a width of the second first partition portion,
for each of the first first and second first partition portions, a lengthwise direction refers to a direction along which the partition portion extends, and a widthwise direction is perpendicular to the direction along which the partition portion extends, and
a length of the at least one first notch in the first first partition portion is the same as a length of the at least one first notch in the second first partition portion.

12. The display panel according to claim 11, wherein:
the at least one first notch in the first first partition portion is located at a respective corner of the first first sub-pixel, and the at least one first notch in the second first partition portion is located at a respective corner of the second first sub-pixel,
along the third direction, two first notches of the at least one first notch in the first first partition portion are located at opposite sides of the first first sub-pixel, and two first notches of the at least one first notch in the second first partition portion are located at opposite sides of the second first sub-pixel, or
along the fourth direction, two first notches of the at least one first notch in the first first partition portion are located at opposite sides of the first first sub-pixel, and two first notches of the at least one first notch in the second first partition portion are located at opposite sides of the second first sub-pixel.

13. The display panel according to claim 1, wherein:
each of the first sub-pixels comprises the protrusion portion and the body portion, wherein the protrusion portion comprises a first edge away from the body portion, and the first edge comprises the arc,
a contour of each of the first sub-pixels has a virtual circumscribed quadrilateral, and the first sub-pixels comprise a first-type sub-pixel, a second-type sub-pixel, a third-type sub-pixel, and a fourth-type sub-pixel, wherein
a direction from a centroid of an orthographic projection of the virtual circumscribed quadrilateral of the first-type sub-pixel onto a plane of the substrate to a center of the first edge is parallel to the first direction,
a direction from a centroid of an orthographic projection of the virtual circumscribed quadrilateral of the second-type sub-pixel onto the plane of the substrate to the center of the first edge is parallel to the second direction,
a direction from a centroid of an orthographic projection of the virtual circumscribed quadrilateral of the third-type sub-pixel onto the plane of the substrate to the center of the first edge is parallel to a direction opposite to the first direction, and
a direction from a centroid of an orthographic projection of the virtual circumscribed quadrilateral of the fourth-type sub-pixel onto the plane of the substrate to the center of the first edge is parallel to a direction opposite to the second direction,
wherein the center of the first edge is a midpoint of a connecting line between two endpoints of the first edge,
in a row of the plurality of sub-pixels, the first-type sub-pixel, the fourth-type sub-pixel, the second-type sub-pixel and the third-type sub-pixel are alternately arranged, and
in a column of the plurality of sub-pixels, the second-type sub-pixel, the third-type sub-pixel, the first-type sub-pixel and the fourth-type sub-pixel are alternately arranged.

14. The display panel according to claim 1, wherein:
the second sub-pixels comprise a first second sub-pixel, and along the third direction or the fourth direction, a support portion of the at least one support portion is disposed between the first second sub-pixel and a first sub-pixel, adjacent to the first second sub-pixel, of the first sub-pixels, and
the second partition portion of the first second sub-pixel comprises a third partition sub-portion partially surrounding the first second sub-pixel, wherein the third partition sub-portion comprises a second notch, which is located at a corner of the first second sub-pixel, of the at least one second notch.

15. The display panel according to claim 14, wherein:
the second notch is located at a side of the first second sub-pixel close to the support portion.

16. The display panel according to claim 14, wherein:
a quantity of the second notches in the third partition sub-portion is at least two, wherein each of the at least two second notches is located at a respective corner of the first second sub-pixel, and
one of the at least two second notches is located at a side of the first second sub-pixel close to the support portion, and another of the at least two second notches is located at a side of the first second sub-pixel away from the support portion.

17. The display panel according to claim 16, wherein:
a length of the second notch that is away from the support portion is S211,
a length of the second notch that is close to the support portion is S212, and
S211≤S212.

18. The display panel according to claim 14, wherein:
the first second sub-pixel further has a plurality of first second edges, wherein two adjacent first second edges form the corner, and the third partition sub-portion further comprises another second notch, which exposes a respective one of the plurality of first second edges, of the at least one second notch,
a length of the second notch exposing the respective first second edge is S213,
a length of the second notch located at the corner of the first second sub-pixel and close to the support portion is S212, and
S213≤S212.

19. The display panel according to claim 1, wherein:
the second sub-pixels comprise a first second sub-pixel, and along the third direction, a support portion of the at least one support portion is disposed between the first second sub-pixel and a first sub-pixel, adjacent to the first second sub-pixel, of the first sub-pixels, and
the first second sub-pixel comprises the protrusion portion and the body portion,
for the first second sub-pixel, at least part of the arc is disposed on a side of the first second sub-pixel close to the support portion, and
the second partition portion of the first second sub-pixel comprises a second edge located between the part of the arc and the support portion.

20. The display panel according to claim 19, wherein:
the second partition portion of the first second sub-pixel further comprises a third edge located at a side of the first second sub-pixel away from the second edge.

21. The display panel according to claim 19, wherein
the body portion of the first second sub-pixel has a first straight segment and a second straight segment, the first straight segment and the second straight segment intersect, one end of the arc is connected to the first straight segment, and the other end of the arc is connected to the second straight segment,
the first straight segment and the second straight segment intersect at a first vertex, and
the second partition portion of the first second sub-pixel further comprises a fourth edge located at a side of the second sub-pixel away from the first vertex.

22. The display panel according to claim 19, wherein:
the first second sub-pixel further has a plurality of first second edges, wherein two adjacent first second edges form a corner, and a third partition sub-portion of the second partition portion of the first second sub-pixel comprises a second notch, which exposes a respective one of the plurality of first second edges, of the at least one second notch,
a length of the second notch exposing the respective first second edge is S213,
a length of the second edge is S22, and
S213≤S22.

23. The display panel according to claim 1, wherein:
each of the second sub-pixels comprises the protrusion portion and the body portion, wherein the protrusion portion comprises a fifth edge away from the body portion,
a contour of each of the second sub-pixels has a virtual circumscribed quadrilateral, and the second sub-pixels comprise a fifth-type sub-pixel, a sixth-type sub-pixel, a seventh-type sub-pixel, and an eighth-type sub-pixel, wherein
a direction from a centroid of an orthographic projection of the virtual circumscribed quadrilateral of the fifth-type sub-pixel onto a plane of the substrate to a center of the fifth edge is parallel to the first direction,
a direction from a centroid of an orthographic projection of the virtual circumscribed quadrilateral of the sixth-type sub-pixel onto the plane of the substrate to the center of the fifth edge is parallel to the second direction,
a direction from a centroid of an orthographic projection of the virtual circumscribed quadrilateral of the seventh-type sub-pixel onto the plane of the substrate to the center of the fifth edge is parallel to a direction opposite to the first direction, and
a direction from a centroid of an orthographic projection of the virtual circumscribed quadrilateral of the eighth-type sub-pixel onto the plane of the substrate to the center of the fifth edge is parallel to a direction opposite to the second direction,
wherein the center of the fifth edge is a midpoint of a connecting line between two endpoints of the fifth edge,
in a row of the plurality of sub-pixels, the fifth-type sub-pixel, the seventh-type sub-pixel, the sixth-type sub-pixel and the eighth-type sub-pixel are alternately arranged, and
in a column of the plurality of sub-pixels, the fifth-type sub-pixel, the eighth-type sub-pixel, the sixth-type sub-pixel and the seventh-type sub-pixel are alternately arranged.

24. The display panel according to claim 1, wherein:
each of the second sub-pixels comprises the protrusion portion and the body portion,
the arc of each of the second sub-pixels comprises a first arc and a second arc, the edge of the protrusion portion away from the body portion further comprises a straight segment connecting the first arc and the second arc, and a length of the first arc is greater than a length of the second arc.

25. The display panel according to claim 1, wherein:
the second sub-pixels comprise a second second sub-pixel, and none of the at least one support portion is disposed between the second second sub-pixel and a first sub-pixel, adjacent to the second second sub-pixel, of the first sub-pixels.

26. The display panel according to claim 25, wherein:
the second partition portion of the second second sub-pixel comprises a fourth partition sub-portion partially surrounding the second second sub-pixel, wherein the fourth partition sub-portion comprises a second notch, which is located at a corner of the second second sub-pixel, of the at least one second notch.

27. The display panel according to claim 25, wherein:
the second second sub-pixel further has a plurality of second second edges, wherein two adjacent second second edges form a corner, and a fourth partition sub-portion of the second partition portion of the second second sub-pixel comprises a second notch, which exposes a respective one of the plurality of second second edges, of the at least one second notch,
a length of the second notch exposing the respective second second edge is S222,
a length of the second notch located at a corner of a first second sub-pixel of the second sub-pixels and close to the support portion is S212, and
S222≤S212.

28. The display panel according to claim 1, wherein:
the second sub-pixels comprise a first second sub-pixel and a second second sub-pixel, a support portion of the at least one support portion is disposed between the first second sub-pixel and a first sub-pixel, adjacent to the first second sub-pixel, of the first sub-pixels, and none of the at least one support portion is disposed between the second second sub-pixel and a first sub-pixel, adjacent to the second second sub-pixel, of the first sub-pixels,
the second partition portion comprises a first second partition portion and a second second partition portion, the first second partition portion at least partially surrounds the first second sub-pixel, and the second second partition portion at least partially surrounds the second second sub-pixel,
a shape of the first second partition portion is the same as a shape of the second second partition portion, and
a length of the at least one second notch in the first second partition portion is the same as a length of the at least one second notch in the second second partition portion.

29. The display panel according to claim 28, wherein:
the at least one second notch in the first second partition portion is disposed to correspond to a respective corner of the first second sub-pixel, and the at least one second notch in the second second partition portion is disposed to correspond to a respective corner of the second second sub-pixel.

30. The display panel according to claim 28, wherein:
the at least one second notch in the first second partition portion is disposed to correspond to a respective edge of the first second sub-pixel, and the at least one second notch in the second second partition portion is disposed to correspond to a respective edge of the second second sub-pixel.

31. The display panel according to claim 1, wherein:
none of the partition portions is disposed at a periphery of any of the third sub-pixels.

32. The display panel according to claim 1, further comprising at least one third partition portion, each at least partially surrounding a respective one of the third sub-pixels and comprising at least one third notch.

33. The display panel according to claim 32, wherein:
a contour of each of the third sub-pixels has a virtual circumscribed rectangle, and a direction from a centroid of an orthographic projection of the virtual circumscribed rectangle of the third sub-pixel onto a plane of the substrate to a center of the third notch is parallel to the first direction or the second direction, wherein the center of the third notch is a midpoint of a connecting line between two endpoints of the third partition portion that define the third notch.

34. The display panel according to claim 32, wherein:
a quantity of the third notches in the third partition portion is at least two,
for two third sub-pixels, adjacently disposed in the third direction, of the third sub-pixels, the at least two third notches at a periphery of one of the two third sub-pixels and the at least two third notches at a periphery of the other of the two third sub-pixels are arranged along the third direction, respectively, and
two of the at least two third notches at the periphery of one of the two third sub-pixels are arranged along a fifth direction, and two of the at least two third notches at the periphery of the other of the two third sub-pixels are arranged along a sixth direction.

35. The display panel according to claim 34, wherein:
the fifth direction is parallel to the first direction.

36. The display panel according to claim 1, wherein each of the plurality of sub-pixels comprises:
a first electrode disposed on the substrate;
a first light-emitting layer disposed at a side of the first electrode away from the substrate;
a charge generation layer disposed at a side of the first light-emitting layer away from the first electrode;
a second light-emitting layer disposed at a side of the charge generation layer away from the first light-emitting layer; and
a second electrode disposed at a side of the second light-emitting layer away from the charge generation layer.

37. The display panel according to claim 1, wherein at least one of:
at least one of the partition portions comprises a protrusion portion protruding away from the substrate, and an area of a top surface of the protrusion portion is greater than an area of a bottom surface of the protrusion portion, or
at least one of the partition portions comprises a recessed portion recessed toward the substrate.

38. The display panel according to claim 1, further comprising a plurality of scan lines and a plurality of data lines, wherein each scan line in the plurality of scan lines extends along the third direction, and each data line in the plurality of data lines extends along the fourth direction.

39. A display apparatus, comprising the display panel according to any one of claims 1 to 38.
